# EUROPEAN PATENT APPLICATION

(11) **EP 4 675 644 A1**
(43) Date of publication of application: **07.01.2026**
(21) Application number: 24763427.2
(22) Date of filing: 22.01.2024
(51) Int. Cl.: G16Z 99/00

(54) **DATA CONTROL METHOD AND DATA CONTROL PROGRAM**

(30) Priority: 01.03.2023 JP 2023031446
(71) Applicant: FUJITSU LIMITED, Kawasaki-shi, Kanagawa 211-8588 (JP)
(72) Inventor: ITAKURA, Kota, Kawasaki-shi, Kanagawa 211-8588 (JP); YAMAOKA, Hisatoshi, Kawasaki-shi, Kanagawa 211-8588 (JP); OKABAYASHI, Miwa, Kawasaki-shi, Kanagawa 211-8588 (JP)
(74) Representative: Hoffmann Eitle
(86) International application number: PCT/JP2024/001681
(87) International publication number: WO 2024/180942

(57) **Abstract**

A data control device (1) successively executes logic based on action logic that describes action of an object. When the fact that the object has moved to a predetermined position is notified from a traffic simulator (3A) in accordance with execution of specific logic, the data control device (1) determines to which of a first shop simulator (3B) and a second shop simulator (3B) data of the object is to be transmitted using an attribute of the object stored in advance. The data control device (1) transmits the data of the object to the shop simulator (3B) to which the data of the object is determined to be transmitted. Such processing of the data control device (1) can be applied to social simulations used in a local government or a transportation infrastructure, for example.

## Description

### Technical Field

The present invention relates to a data control method and a data control program.

### Background Art

In recent years, there is a demand for a simulation that links a plurality of simulators to traverse a plurality of fields. For example, in a social simulation, there is a demand to link many simulators. The social simulation herein means a simulation for studying problems in social sciences, and is used for previously examining what would occur when a policy is implemented in a society.

There is known a Function Mock-up Interface (FMI) that is a standard interface for linking a plurality of simulators. The FMI is a standard interface for exchanging simulation results between different simulators. For example, the FMI can be used in automobile design by complying with each of simulators that reproduce an engine or steering behavior configuring an automobile, and integrating the simulators.

There is also known a High Level Architecture (HLA) that is a standard for linking a plurality of simulators. The HLA is a standard for interconnecting and linking different simulators on a network. For example, the HLA is used for a military simulation and the like, defines an object that performs arbitration for linkage between simulators, and links the simulators via the object. There is an object management service for sharing data between simulators.

There is disclosed a technique of enabling an overall simulation by linking a plurality of different simulators (for example, refer to Patent Literature 1). In such a technique, an integrated simulator system connected to a plurality of simulation devices acquires component information indicating a component as a target of the simulation from each of a plurality of simulators, displays the acquired component information, connects and arranges the component information based on an arrangement instruction from a user corresponding to the displayed component information, and sets a connection attribute between arranged components. That is, the integrated simulator system shares data between the simulators.

### Citation List

### Patent Literature

Patent Literature 1: Japanese Patent Application Laid-open No. 2011-107962

### Summary of invention

### Technical Problem

However, in linkage between simulations in social simulations, a linkage destination may change depending on a state of data to be linked, and the linkage destination may often change depending on a policy and the like to be simulated. For this reason, there is a problem in that work of creating or updating control described in each simulator that executes a simulation and the like requires much labor.

For example, in a technique of enabling an overall simulation and HLA, there are systems and services for sharing data between simulators. However, also in simulations in the respective simulators, a linkage destination may change depending on a state of data to be linked, and the linkage destination may often change depending on a policy and the like to be simulated.

According to one aspect, the present invention aims at facilitating work of creating or updating control described in each simulator and the like.

### Solution to Problem

In one aspect, a data control method for linking pieces of data among a plurality of simulators includes processing of, by a control unit that controls linkage among the pieces of data, successively executing logic based on action logic that describes action of a target, determining, when a fact that the target has moved to a predetermined position is notified from a first simulator in accordance with execution of specific logic, to which of a second simulator and a third simulator data of the target is to be transmitted using an attribute of the target stored in advance, and transmitting the data of the target to a simulator to which the data of the target is determined to be transmitted.

### Advantageous Effects of Invention

According to one aspect, it is possible to facilitate work of creating or updating control described in each simulator and the like.

### Brief Description of Drawings

FIG. 1 is a block diagram illustrating an example of a functional configuration of a data control system according to a first embodiment.
FIG. 2A is a diagram (1) illustrating an image of a data control method according to the first embodiment.
FIG. 2B is a diagram (2) illustrating an image of the data control method according to the first embodiment.
FIG. 3 is a diagram illustrating an example of overall information according to the first embodiment.
FIG. 4 is a diagram illustrating an example of simulation information according to the first embodiment.
FIG. 5 is a diagram illustrating an example of simulator linkage information according to the first embodiment.
FIG. 6 is a diagram illustrating an example of logic according to the first embodiment.
FIG. 7 is a diagram illustrating an example of object internal information according to the first embodiment.
FIG. 8 is a diagram illustrating an example of object linkage information according to the first embodiment.
FIG. 9 is a diagram illustrating an example of data control among simulators according to the first embodiment.
FIG. 10A is a diagram (1) illustrating an example of a flow of data control according to the first embodiment.
FIG. 10B is a diagram (2) illustrating an example of a flow of data control according to the first embodiment.
FIG. 10C is a diagram (3) illustrating an example of a flow of data control according to the first embodiment.
FIG. 10D is a diagram (4) illustrating an example of a flow of data control according to the first embodiment.
FIG. 10E is a diagram (5) illustrating an example of a flow of data control according to the first embodiment.
FIG. 10F is a diagram (6) illustrating an example of a flow of data control according to the first embodiment.
FIG. 10G is a diagram (7) illustrating an example of a flow of data control according to the first embodiment.
FIG. 10H is a diagram (8) illustrating an example of a flow of data control according to the first embodiment.
FIG. 11 is a diagram illustrating an example of a flowchart of object management processing according to the first embodiment.
FIG. 12 is a diagram illustrating an example of a flowchart of simulator management processing according to the first embodiment.
FIG. 13 is a diagram illustrating an example of a flowchart of simulation execution management processing according to the first embodiment.
FIG. 14 is a diagram illustrating an image of a data control method according to a second embodiment.
FIG. 15 is a block diagram illustrating an example of a functional configuration of a data control system according to the second embodiment.
FIG. 16 is a diagram illustrating an example of determining the number of non-participation steps according to the second embodiment.
FIG. 17 is a diagram illustrating another example of determining the number of non-participation steps according to the second embodiment.
FIG. 18 is a diagram illustrating a specific example of non-participation rules according to the second embodiment.
FIG. 19A is a diagram (1) illustrating an example of a flow of data control according to the second embodiment.
FIG. 19B is a diagram (2) illustrating an example of a flow of data control according to the second embodiment.
FIG. 19C is a diagram (3) illustrating an example of a flow of data control according to the second embodiment.
FIG. 19D is a diagram (4) illustrating an example of a flow of data control according to the second embodiment.
FIG. 19E is a diagram (5) illustrating an example of a flow of data control according to the second embodiment.
FIG. 19F is a diagram (6) illustrating an example of a flow of data control according to the second embodiment.
FIG. 19G is a diagram (7) illustrating an example of a flow of data control according to the second embodiment.
FIG. 19H is a diagram (8) illustrating an example of a flow of data control according to the second embodiment.
FIG. 19I is a diagram (9) illustrating an example of a flow of data control according to the second embodiment.
FIG. 19J is a diagram (10) illustrating an example of a flow of data control according to the second embodiment.
FIG. 19K is a diagram (11) illustrating an example of a flow of data control according to the second embodiment.
FIG. 19L is a diagram (12) illustrating an example of a flow of data control according to the second embodiment.
FIG. 20 is a diagram illustrating an example of a flowchart of object management processing according to the second embodiment.
FIG. 21 is a diagram illustrating an example of a flowchart of processing of determining the number of non-participation steps according to the second embodiment.
FIG. 22 is a diagram illustrating another example of a flowchart of the processing of determining the number of non-participation steps according to the second embodiment.
FIG. 23 is a diagram illustrating an example of a flowchart of simulator management processing according to the second embodiment.
FIG. 24 is a diagram illustrating an example of a computer that executes a data control program.

### Embodiments for Carrying Out the Invention

The following describes embodiments of a data control method and a data control program disclosed herein in detail based on the drawings. The present invention is not limited to the embodiments.

### First embodiment

### <Functional configuration of data control system>

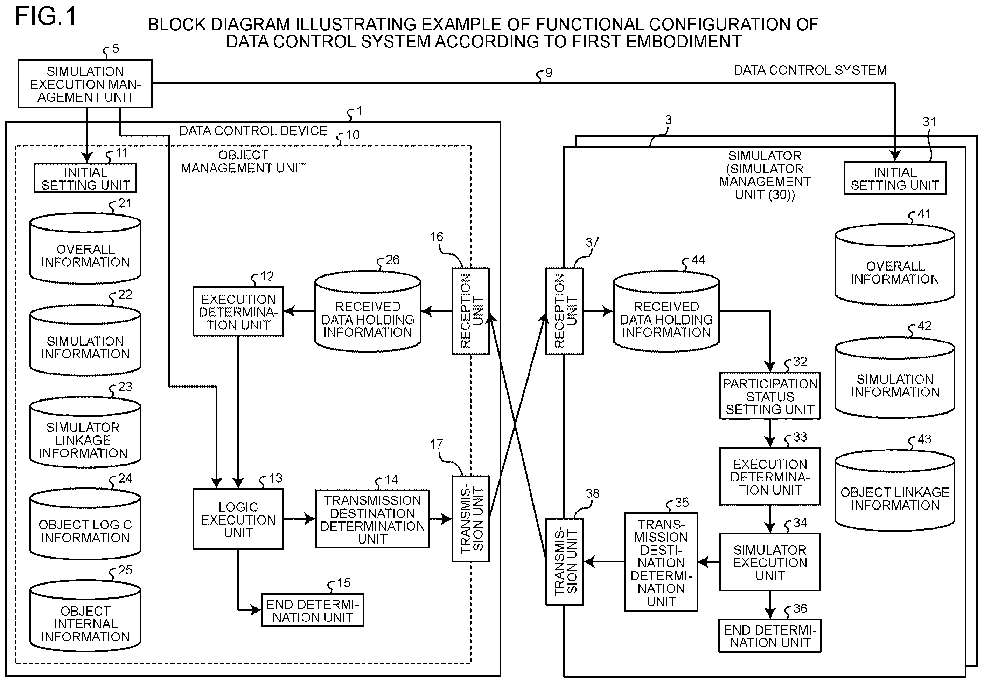

FIG. 1 is a block diagram illustrating an example of a functional configuration of a data control system according to a first embodiment. As illustrated in FIG. 1, a data control system 9 includes a data control device 1, a plurality of simulators 3, and a simulation execution management unit 5. The data control device 1 receives an instruction to start simulation execution from the simulation execution management unit 5, and links pieces of data among the simulators 3. The data control device 1 executes, for each target, logic based on the logic (behavior) associated with the target, and performs participation, withdrawal from participation (non-participation), data transmission, and the like for each of the simulators 3 in accordance with an execution result. That is, the data control device 1 has logic (behavior) for each target, and links pieces of data among the simulators 3 based on the logic of each target. Herein, the target means an object such as a person. The simulator 3 is a simulator that executes a social simulation. Examples of the simulator 3 include, for example, a traffic simulator, a shop simulator, and the like. The traffic simulator simulates, for example, waking movement of an object (person and the like) on a road, and reproduces time taken for movement, road congestion, and the like in a simulated manner. The shop simulator simulates, for example, behavior of an object (person) in a shop using a state transition model and the like, and reproduces an inventory status of products, a queue of people, and the like in the shop in a simulated manner.

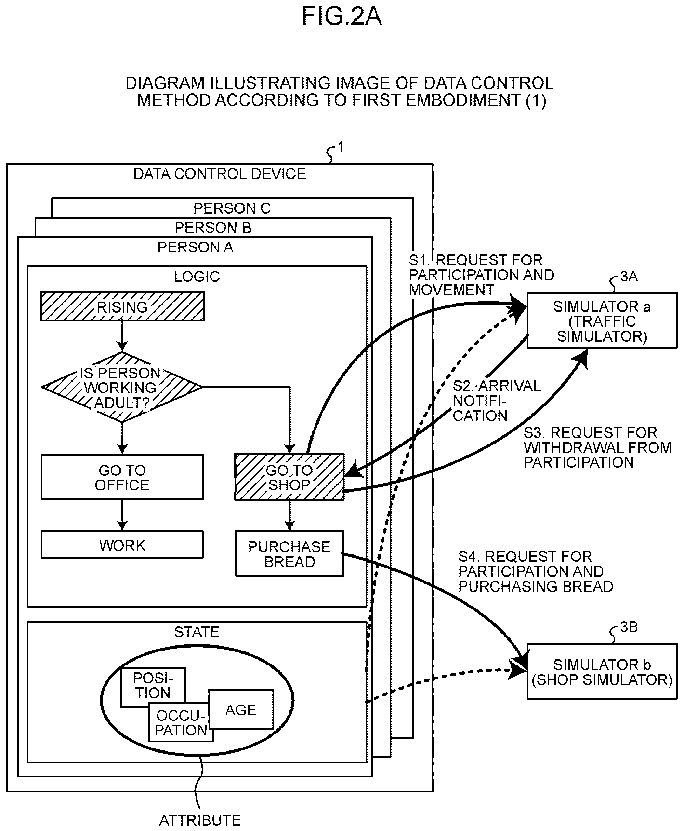

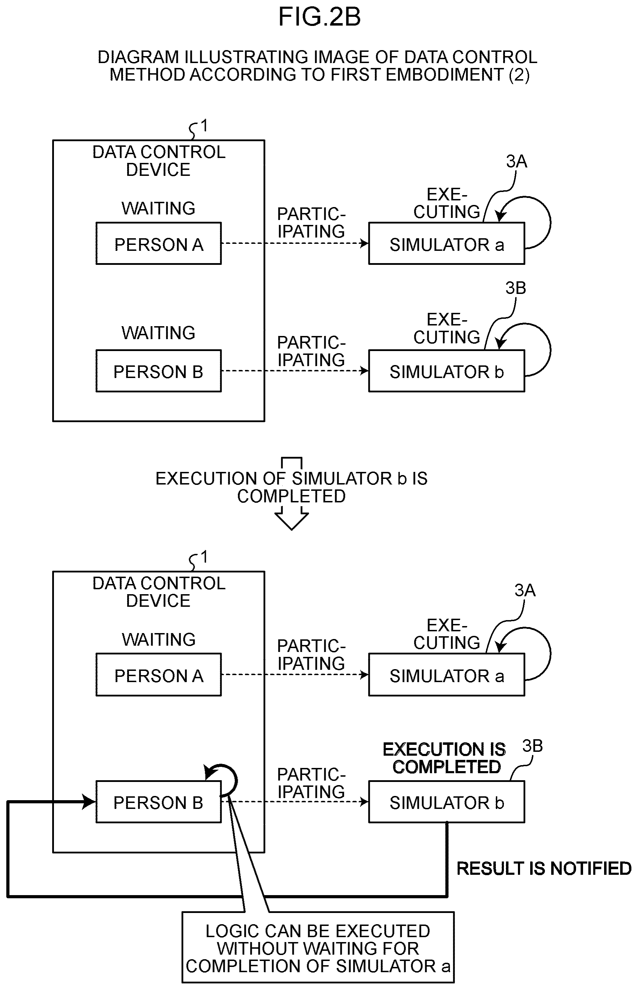

Herein, the following describes an image of a data control method according to the first embodiment with reference to FIG. 2A and FIG. 2B. FIG. 2A and FIG. 2B are diagrams illustrating an image of the data control method according to the first embodiment. In FIG. 2A and FIG. 2B, the target is assumed to be a person, and the simulators 3 are assumed to be a simulator a (3A) and a simulator b (3B).

As illustrated in FIG. 2A, the data control device 1 has information including logic, an attribute, and a state of each person. Herein, the data control device 1 has information of a person A and information of a person B. It is assumed that the simulator a (3A) is, for example, a traffic simulator, and the simulator b (3B) is, for example, a shop simulator.

The data control device 1 then executes logic based on the logic (behavior) associated with the person A, and in accordance with an execution result, transmits a request for participation, a request for withdrawal from participation, other pieces of data, and the like to the traffic simulator 3A and the shop simulator 3B. Also for the person B, the data control device 1 executes logic based on the logic (behavior) associated with the person B, and in accordance with an execution result, transmits a request for participation, a request for withdrawal from participation, other pieces of data, and the like to the traffic simulator 3A and the shop simulator 3B.

Herein, for example, the data control device 1 performs processing in the logic of "go to shop" for the person A, and makes a request for participation and movement to the traffic simulator 3A (S1). At this point, the data control device 1 holds "participation in the simulator A" in a state associated with the person A. When receiving an arrival notification about the person A from the traffic simulator 3A (S2), the data control device 1 executes processing in the next logic of "purchase bread", and makes a request for withdrawal from participation to the traffic simulator 3A (S3). At this point, the data control device 1 holds "non-participation in the simulator A" in the state associated with the person A. Additionally, the data control device 1 selects the shop simulator 3B as a transmission destination to which the data is transmitted in accordance with the attribute of the person A, and makes a request for participation and a request for purchasing bread to the shop simulator 3B (S4). At this point, the data control device 1 holds "participation in the simulator B" in the state associated with the person A. In this manner, the data control device 1 performs processing in the logic based on the logic (behavior) associated with the person, and in accordance with the execution result, transmits a request for participation, a request for withdrawal from participation, other pieces of data, and the like to the traffic simulator 3A and the shop simulator 3B.

Due to this, the simulator 3 does not need to perform linkage among the simulators 3, and it is sufficient to describe only its own simulation operation, so that description is facilitated. That is, work of creating or updating control described in each of the simulators 3 and the like is facilitated. Additionally, the behavior of the object can be consistently described as logic, so that the work of creating or updating the logic and the like is facilitated.

FIG. 2B illustrates a timing for advancing processing in the logic. For each person, if simulator results are notified from all of the simulators 3 participation for which is held, the data control device 1 performs the next processing in the logic.

Herein, the person A is participating in the simulator a (3A), and the simulator a (3A) is executing a relevant simulation. The person A is not participating in the simulator b (3B). The person B is participating in the simulator b (3B), and the simulator b (3B) is executing a relevant simulation. It is assumed that execution by the simulator b (3B) is completed.

When receiving a simulation result notification from the simulator b (3B) for the person B, the data control device 1 performs the next processing in the logic because the simulator results are notified from all of participating simulators 3. That is, when receiving a simulation result notification from the simulator b (3B) for the person B, the data control device 1 can perform the next processing in the logic without waiting for completion of the simulator a.

Due to this, the data control device 1 can efficiently advances the logic of the target by advancing the processing in the logic without waiting for a notification from a non-participating simulator.

### <Functional configuration of data control device>

Returning to FIG. 1, the data control device 1 includes an object management unit 10. The object management unit 10 is provided for each object. The object herein is an example of the target. The object management unit 10 executes, for each object, the logic based on the logic (behavior) associated with each object, and in accordance with an execution result, transmits a request for participation, a request for withdrawal from participation (non-participation), other pieces of data, and the like to each simulator 3. The object management unit 10 includes an initial setting unit 11, an execution determination unit 12, a logic execution unit 13, a transmission destination determination unit 14, an end determination unit 15, a reception unit 16, and a transmission unit 17. The object management unit 10 also includes overall information 21, simulation information 22, simulator linkage information 23, object logic information 24, object internal information 25, and received data holding information 26.

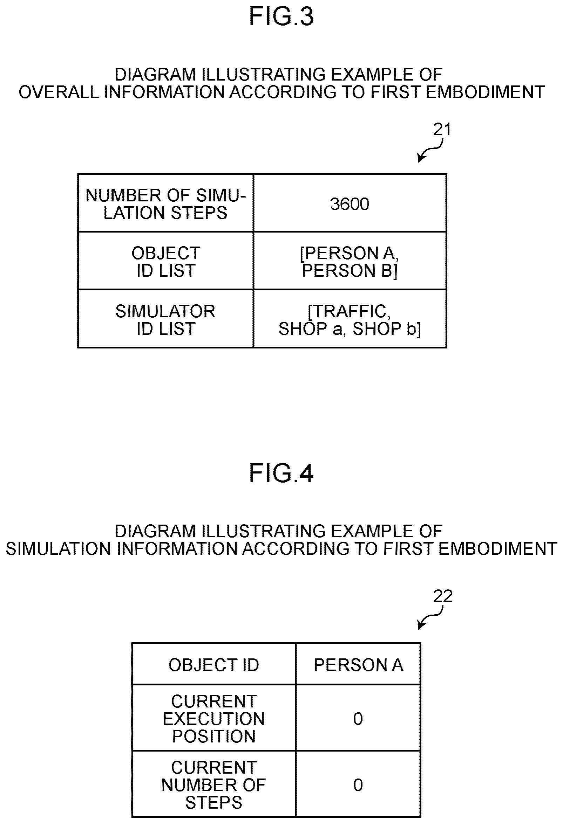

The overall information 21 is information indicating a definition of the entire simulation executed by the data control system 9. The overall information 21 is defined in advance. The following describes an example of the overall information 21 with reference to FIG. 3. FIG. 3 is a diagram illustrating an example of the overall information according to the first embodiment. As illustrated in FIG. 3, the overall information 21 is information in which the number of simulation steps, an object ID list, and a simulator ID are associated with each other. The number of simulation steps is a total number of steps of the simulation executed by the data control system 9. The number of steps means a period, and represented in seconds as an example. The object ID list is a list of IDs that uniquely identify the object as a target. The simulator ID list is a list of IDs that uniquely identify the simulator 3 that executes a simulation.

By way of example, the overall information 21 stores "3600" (seconds) as the number of simulation steps, "person A, person B" as the object ID list, and "traffic, shop a, shop b" as the simulator ID list. The "traffic" means, for example, a traffic simulator. Each of the "shop a" and "shop b" means, for example, a shop simulator.

Returning to FIG. 1, the simulation information 22 is information that manages a current execution position of the logic for the object and a current number of steps of the simulation. The following describes an example of the simulation information 22 with reference to FIG. 4. FIG. 4 is a diagram illustrating an example of the simulation information according to the first embodiment. As illustrated in FIG. 4, the simulation information 22 is information in which the object ID, the current execution position, and the current number of steps are associated with each other. The object ID is an ID that uniquely identifies the object. The current execution position is a current execution position of the logic. The current number of steps is a current number of steps of the simulation.

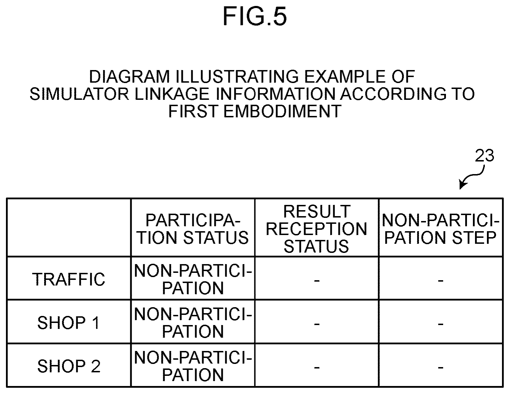

Returning to FIG. 1, the simulator linkage information 23 is information that manages linkage with each of the simulators 3. The following describes an example of the simulator linkage information 23 with reference to FIG. 5. FIG. 5 is a diagram illustrating an example of the simulator linkage information according to the first embodiment. As illustrated in FIG. 5, the simulator linkage information 23 is information in which a participation status, a result reception status, and a non-participation step are associated with each of the simulators 3.

The participation status is information indicating whether the object is participating or not participating in the simulator 3. As the participation status, by way of example, "participation" indicating that the object is participating, and "non-participation" indicating that the object is not participating are set. The result reception status is information indicating whether a simulation result is received from the participating simulator 3. As the result reception status, by way of example, "received" indicating that the simulation result is received, and "unreceived" indicating that the simulation result is not received are set. The non-participation step is, in a case in which there is a period (the number of steps) in which the object does not participate in the simulator 3, information indicating the number of steps. The non-participation step is not used in the first embodiment.

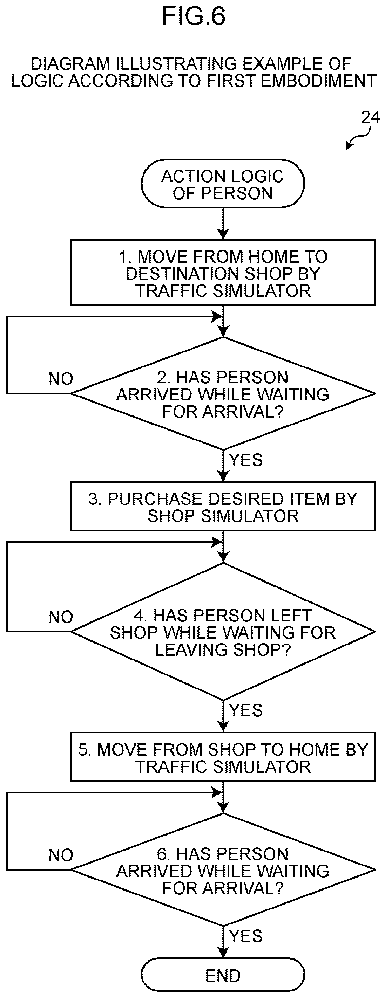

Returning to FIG. 1, the object logic information 24 is information of the logic in which action of the object is described. That is, the object logic information 24 is information that describes behavior of the object. The object logic information 24 is defined in advance for each object. Herein, the following describes an example of the logic with reference to FIG. 6. FIG. 6 is a diagram illustrating an example of the logic according to the first embodiment. As illustrated in FIG. 6, represented is the logic regarding action of a certain object (herein, a person) included in the object ID list. A numeral on the left of each piece of processing included in the logic is a numeral indicating order of processing (execution position). The logic is executed in ascending order of numerals. Hereinafter, each piece of processing included in the logic is referred to as "logic processing".

In the example of FIG. 6, action logic of the person moves from a home to a destination shop by the traffic simulator (execution position 1). The action logic of the person then executes processing of determining whether the person has arrived while waiting for arrival (execution position 2). If it is determined that the person has not arrived (execution position 2: No), the action logic of the person repeats the determination processing until the person arrives. On the other hand, if it is determined that the person has arrived (execution position 2: Yes), the action logic of the person purchases a desired item by the shop simulator (execution position 3). The action logic of the person then performs processing of determining whether the person has left the shop while waiting for leaving the shop (execution position 4). If it is determined that the person has not left the shop (execution position 4: No), the action logic of the person repeats the determination processing until the person leaves the shop. On the other hand, if it is determined that the person has left the shop (execution position 4: Yes), the action logic of the person moves from the shop to the home by the traffic simulator (execution position 5). The action logic of the person then determines whether the person has arrived while waiting for arrival (execution position 6). If it is determined that the person has not arrived (execution position 6: No), the action logic of the person repeats the determination processing until the person arrives. On the other hand, if it is determined that the person has arrived (execution position 6: Yes), the action logic of the person ends the logic. The destination shop and the desired item are set to the object internal information 25 (described later).

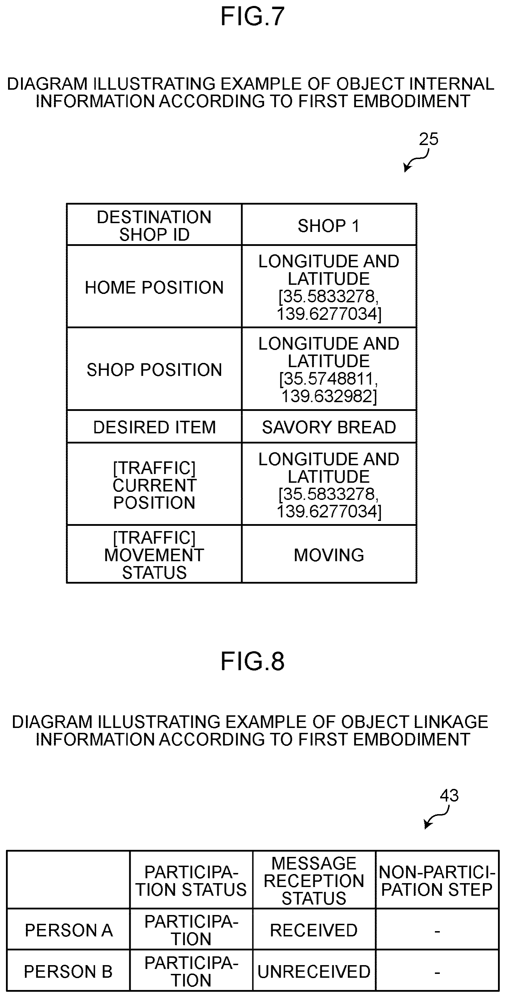

Returning to FIG. 1, the object internal information 25 is internal information corresponding to the object. The following describes an example of the object internal information 25 with reference to FIG. 7. FIG. 7 is a diagram illustrating an example of the object internal information according to the first embodiment. As illustrated in FIG. 7, the object internal information 25 is information in which a destination shop ID, a home position, a shop position, a desired item, a [traffic] current position, and a [traffic] movement status are associated with each other.

The destination shop ID is an ID that uniquely identifies a shop as a destination. The home position is a position of the home of the object. The shop position is a position of the destination shop. The desired item is an item that the object desires to purchase at the destination shop. The destination shop ID, the home position, the shop position, and the desired item are set in advance. The [traffic] current position is a current position of the object simulated by the traffic simulator. The [traffic] movement status is a movement status of the object simulated by the traffic simulator. As the movement status, by way of example, "moving" indicating that the object is moving to the destination, and "arrived" indicating that the object has arrived at the destination are set. The [traffic] current position and the [traffic] movement status are set at a timing when simulation results are returned by the traffic simulator.

Returning to FIG. 1, the received data holding information 26 is information that holds, as received data, a simulation result transmitted from the simulator 3.

The initial setting unit 11 performs initial setting. For example, when receiving an instruction to start simulation execution from the simulation execution management unit 5, the initial setting unit 11 sets the current execution position and the current number of steps of the simulation information 22 to "0" as an initial value. The initial setting unit 11 sets a participation status corresponding to each simulator of the simulator linkage information 23 to "non-participation" as an initial value, and sets result reception information to "-" as an initial value. The initial setting unit 11 then sets the current position and the movement status of the object internal information 25 to "-" as an initial value.

The execution determination unit 12 determines execution of the logic. For example, the execution determination unit 12 waits for reception of a simulation result from the participating simulator 3. When receiving the simulation result from the participating simulator 3, the execution determination unit 12 sets the result reception status corresponding to the simulator 3 in the simulator linkage information 23 to "received". Additionally, when receiving a simulation result from the traffic simulator, the execution determination unit 12 sets a current position and a movement status included in the simulation result to a relevant portion in the object internal information 25. If result reception statuses corresponding to all participating simulators 3 are "received", the execution determination unit 12 determines to perform the next logic processing. That is, if a simulation result is received from the participating simulator 3 for the object as a target, the execution determination unit 12 determines to execute the next logic processing without waiting for reception of the simulation result from the non-participating simulator 3. If the result reception status corresponding to any of the participating simulators 3 is not "received", the execution determination unit 12 determines not to execute the next logic processing.

Due to this, the execution determination unit 12 can efficiently advance the logic of the target by advancing the logic processing without waiting for reception of the simulation result from the non-participating simulator 3.

The logic execution unit 13 executes the logic. For example, when receiving an instruction to start simulation execution from the simulation execution management unit 5, the logic execution unit 13 executes the first logic processing. If the execution determination unit 12 determines to execute the next logic processing, the logic execution unit 13 executes the next logic processing. The logic execution unit 13 then determines participation, non-participation, or withdrawal from participation in the simulator 3 based on an execution result.

The transmission destination determination unit 14 determines a transmission destination. For example, with reference to the simulator linkage information 23, the transmission destination determination unit 14 determines the simulator 3 the participation status of which is "participation" to be a transmission destination of a message indicating participation, and sets a reception status to "unreceived". For each of the simulators 3, with reference to the simulator linkage information 23, the transmission destination determination unit 14 determines the simulator 3 the participation status of which is "non-participation" to be a transmission destination of a message indicating non-participation, and sets the reception status to **"-"** to be cleared.

The end determination unit 15 determines the end of simulations by the simulators 3. For example, the end determination unit 15 acquires the current number of steps from the simulation information 22. The end determination unit 15 also acquires the number of simulation steps from the overall information 21. If the current number of steps is equal to or larger than the number of simulation steps, the end determination unit 15 determines to end the simulation. If the current number of steps is smaller than the number of simulation steps, the end determination unit 15 continues the simulation.

The reception unit 16 receives a simulation result transmitted from each of the simulators 3 to the object. The reception unit 16 then associates the received simulation result for the object with the simulator 3 to be stored in the received data holding information 26 of the object. The reception unit 16 is, for example, implemented by a Network Interface Card (NIC) and the like.

The transmission unit 17 transmits various messages to the simulator 3 as the transmission destination determined by the transmission destination determination unit 14 for the object. The transmission unit 17 is, for example, implemented by an NIC and the like.

### <Functional configuration of simulator>

The simulator 3 includes a simulator management unit 30. The simulator management unit 30 executes a simulation specific to the simulator 3. The simulator management unit 30 includes an initial setting unit 31, a participation status setting unit 32, an execution determination unit 33, a simulator execution unit 34, a transmission destination determination unit 35, an end determination unit 36, a reception unit 37, and a transmission unit 38. The simulator management unit 30 also includes overall information 41, simulation information 42, object linkage information 43, and received data holding information 44.

The overall information 41 is information indicating a definition of the entire simulation executed by the data control system 9. The overall information 41 has the same content as that of the overall information 21 in the object management unit 10, so that the description thereof will not be repeated.

The simulation information 42 is information that manages a current number of steps of a simulation for the simulator 3. The simulation information 42 is information in which a simulation ID and the current number of steps are associated with each other. The simulation ID is an ID that uniquely identifies the simulator 3 that executes a simulation. The current number of steps is a current number of steps of a simulation for the simulator 3.

The object linkage information 43 is information that manages linkage with each object. The following describes an example of the object linkage information 43 with reference to FIG. 8. FIG. 8 is a diagram illustrating an example of the object linkage information according to the first embodiment. As illustrated in FIG. 8, the object linkage information 43 is information in which the participation status, the message reception status, and the non-participation step are associated with each object.

The participation status is information indicating whether the object is participating or not participating. As the participation status, by way of example, "participation" indicating that the object is participating, and "non-participation" indicating that the object is not participating are set. The message reception status is information indicating whether a message has been received from the object. As the message reception status, by way of example, "received" indicating that the message has been received, and "unreceived" indicating that the message has not been received are set. The non-participation step is, in a case in which there is a period (number of steps) in which the object does not participate in the simulator 3, information indicating the number of steps. The non-participation step is not used in the first embodiment.

The received data holding information 44 is information that holds a message transmitted from the data control device 1 as received data.

Returning to FIG. 1, the initial setting unit 31 performs initial setting. For example, the initial setting unit 31 receives an instruction to start simulation execution from the simulation execution management unit 5, and sets the current number of steps of the simulation information 42 to "0" as an initial value. The initial setting unit 31 then sets the participation status corresponding to each object of the object linkage information 43 to "non-participation" as an initial value, and sets the message reception status to "-" as an initial value.

The participation status setting unit 32 sets the participation status for the object. For example, the participation status setting unit 32 waits for various messages from the object management unit 10. When receiving a message indicating participation from the object management unit 10, the participation status setting unit 32 sets the participation status corresponding to a relevant object in the object linkage information 43 to "participation", and sets the message reception status to "received". When receiving a message indicating non-participation from the object management unit 10, the participation status setting unit 32 sets the participation status corresponding to the relevant object in the object linkage information 43 to "non-participation", and sets the message reception status to "received".

The execution determination unit 33 determines execution of the simulation. For example, if reception statuses corresponding to all of the objects are "received", the execution determination unit 33 determines to execute the simulation. If the reception status corresponding to any of the objects is not "received", the execution determination unit 33 determines not to execute the simulation.

The simulator execution unit 34 executes a simulation specific to the simulator 3. For example, if the execution determination unit 33 determines to execute the simulation, the simulator execution unit 34 executes the simulation.

The transmission destination determination unit 35 determines a transmission destination. For example, with reference to the object linkage information 43, the transmission destination determination unit 35 determines the object the participation status of which is "participation" to be a transmission destination of a simulation result, and sets the reception status to "unreceived".

The end determination unit 36 determines the end of the simulation specific to the simulator 3. For example, the end determination unit 36 acquires the current number of steps from the simulation information 42. The end determination unit 36 also acquires the number of simulation steps from the overall information 41. If the current number of steps is equal to or larger than the number of simulation steps, the end determination unit 36 determines to end the simulation. If the current number of steps is smaller than the number of simulation steps, the end determination unit 36 continues the simulation.

The reception unit 37 receives various messages transmitted from each object management unit 10. The reception unit 37 then associates the received various messages with the object indicated by the object management unit 10 to be stored in the received data holding information 44. The reception unit 37 is, for example, implemented by a Network Interface Card (NIC) and the like.

The transmission unit 38 transmits a simulation result to the object management unit 10 as a transmission destination determined by the transmission destination determination unit 35. The transmission unit 38 is, for example, implemented by an NIC and the like.

### <Functional configuration of simulation execution management unit>

The simulation execution management unit 5 manages execution of the simulation. For example, the simulation execution management unit 5 instructs the object management unit 10 corresponding to each object and the simulators 3 to start simulation execution. A timing of instruction to start simulation execution may be when a start instruction is received from a system administrator, or when a time determined in advance is reached.

### <Example of data control>

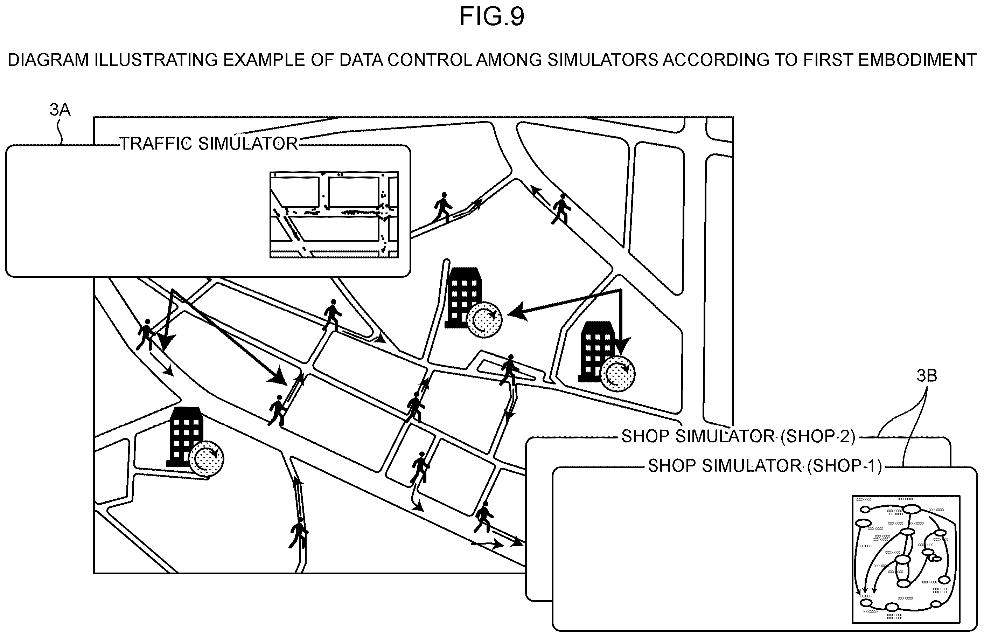

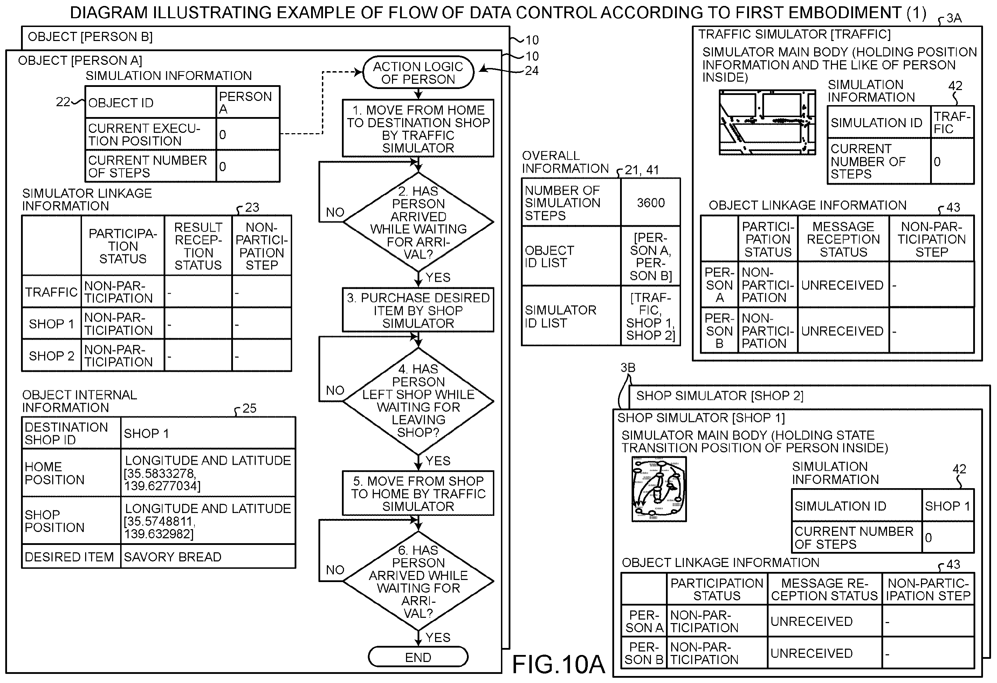

The following describes an example of data control according to the first embodiment with reference to FIG. 9 and FIG. 10A to FIG. 10H. FIG. 9 is a diagram illustrating an example of data control among simulators according to the first embodiment. The data control among the simulators 3 illustrated in FIG. 9 is performed in a case of "going to a shop for shopping". Such data control is linked among one traffic simulator 3A and a plurality of the shop simulators 3B.

FIG. 10A to FIG. 10H are diagrams illustrating an example of a flow of data control according to the first embodiment.

As illustrated in FIG. 10A, there are the object management unit 10 corresponding to an object having an ID of "person A" and the object management unit 10 corresponding to an object having an ID of "person B". As the shop simulators 3B, there are the shop simulator 3B having an ID of "shop 1" and the shop simulator 3B having an ID of "shop 2". There is one traffic simulator 3A having an ID of "traffic". It is assumed that the object of "person A" and the object of "person B" move with the same logic. Each logic to be applied is the same as the logic illustrated in FIG. 6, and stored in each piece of the object logic information 24. The simulation information 22, the simulator linkage information 23, and the object internal information 25 in each of the object management units 10 are in an initial state. That is, in the simulation information 22 of the object "person A", "0" is set as the current execution position and "0" is set as the current number of steps. In the simulator linkage information 23 of the object "person A", "non-participation" is set to the participation status for each simulator, and "-" is set to the result reception status for each simulator. The simulation information 42 and the object linkage information 43 in each of the simulators 3A and 3B are in an initial state. That is, in the simulation information 42 of the traffic simulator 3A and the shop simulator 3B, "0" is set as the current number of steps. In the object linkage information 43 of the traffic simulator 3A and the shop simulator 3B, "non-participation" is set to the participation status for each object, and "unreceived" is set to the message reception status for each object.

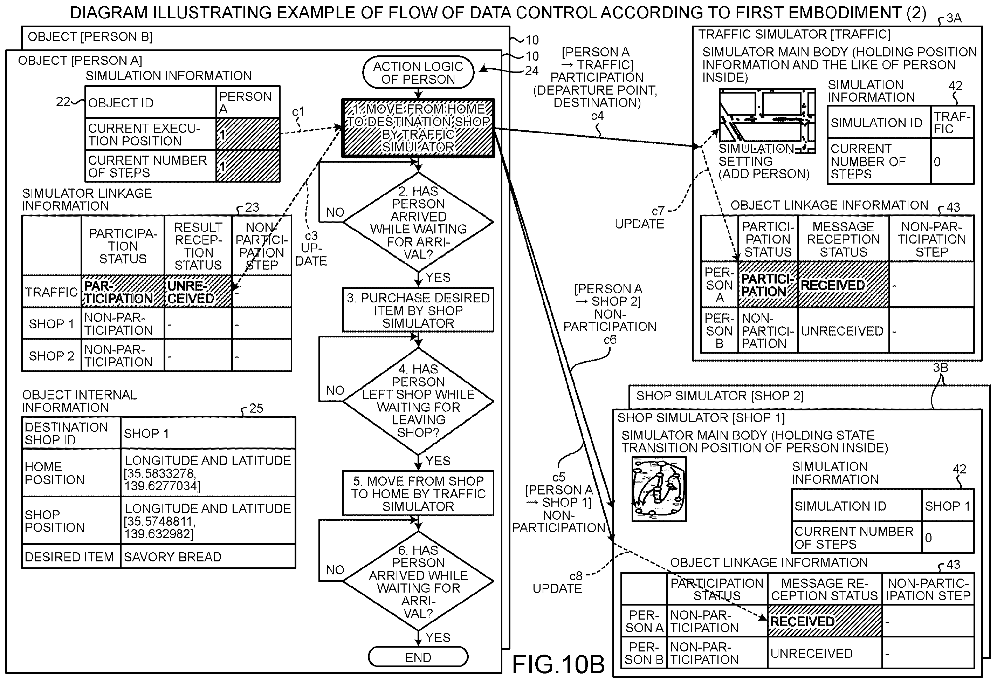

As illustrated in FIG. 10B, for the object management unit 10 of "person A", the logic execution unit 13 receives an instruction to start simulation execution from the simulation execution management unit 5. The logic execution unit 13 then sets, for the simulation information 22, the current execution position of action logic to "1", and sets the current number of steps to "1" (c1). The logic execution unit 13 then executes the first logic processing of the action logic (c2). Herein, the first logic processing of "move from home to destination shop by traffic simulator" is executed. The logic execution unit 13 then determines participation in the traffic simulator 3A based on an execution result of the logic processing. The logic execution unit 13 then sets the participation status corresponding to the traffic simulator 3A in the simulator linkage information 23 to "participation". Additionally, the transmission destination determination unit 14 determines the traffic simulator 3A the participation status of which is "participation" to be a transmission destination of a participation message with reference to the simulator linkage information 23, and updates the reception status to "unreceived" (c3). With reference to the simulator linkage information 23, the transmission destination determination unit 14 determines the shop simulators 3B of "shop 1" and "shop 2" the participation statuses of which are "non-participation" to be transmission destinations of a non-participation message, and sets the reception status to "-" to be cleared.

The transmission unit 17 transmits a participation message including a departure point and a destination to the traffic simulator 3A as the transmission destination determined by the transmission destination determination unit 14 (c4). Herein, the departure point is "home" and the destination is "shop 1". The departure point and the destination are set in the object internal information 25. The transmission unit 17 transmits non-participation messages to the shop simulators 3B of "shop 1" and "shop 2" as transmission destinations determined by the transmission destination determination unit 14 (c5, c6).

In the traffic simulator 3A that has received the participation message from the object management unit 10 of "person A", the participation status setting unit 32 sets the participation status corresponding to "person A" in the object linkage information 43 to "participation", and sets the message reception status to "received" (c7). The traffic simulator 3A then adds "person A" to a simulation main body, and holds position information of the departure point and the destination of "person A" in the simulation main body.

In the shop simulator 3B of "shop 1" that has received the non-participation message from the object management unit 10 of "person A", the participation status setting unit 32 updates the participation status corresponding to "person A" in the object linkage information 43 to "non-participation", and updates the message reception status to "received" (c8). In the shop simulator 3B of "shop 2" that has received the non-participation message from the object management unit 10 of "person A", the participation status setting unit 32 updates the participation status corresponding to "person A" in the object linkage information 43 to "non-participation", and updates the message reception status to "received".

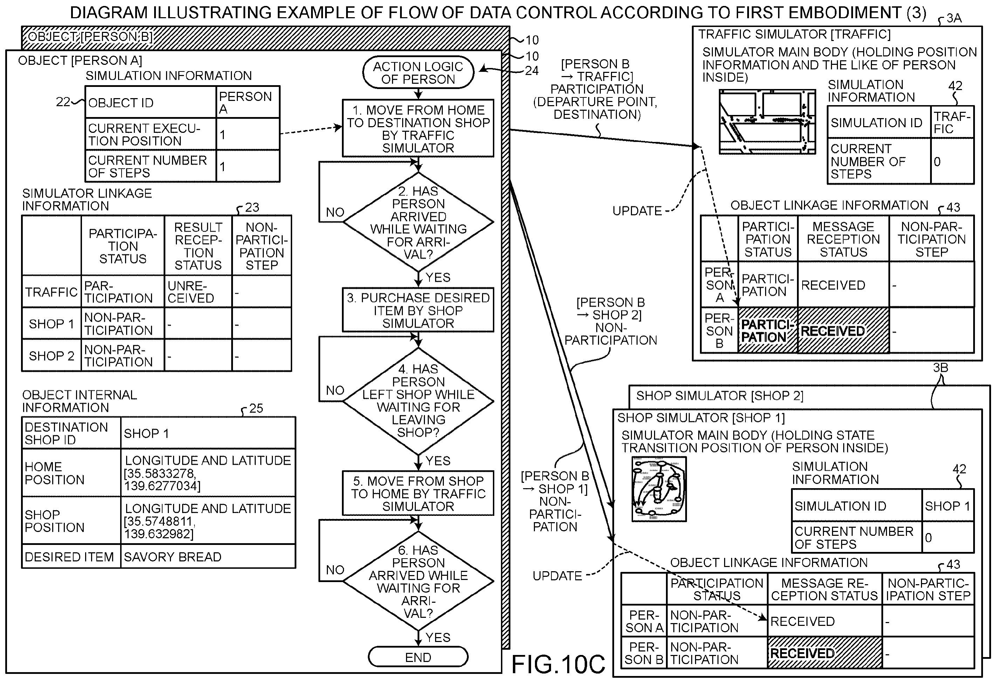

As illustrated in FIG. 10C, for the object management unit 10 of "person B", the logic is executed similarly to the case of the object management unit 10 of "person A". As a result, the simulator linkage information 23 becomes the same as a result illustrated in FIG. 10B.

In the traffic simulator 3A, the participation status setting unit 32 updates the participation status corresponding to "person B" in the object linkage information 43 to "participation", and updates the message reception status to "received". The traffic simulator 3A then adds "person B" to the simulation main body, and holds position information of the departure point and the destination of "person B" in the simulation main body. In the shop simulator 3B of "shop 1", the participation status setting unit 32 updates the participation status corresponding to "person B" in the object linkage information 43 to "non-participation", and updates the message reception status to "received". In the shop simulator 3B of "shop 2", the participation status setting unit 32 updates the participation status corresponding to "person B" in the object linkage information 43 to "non-participation", and updates the message reception status to "received".

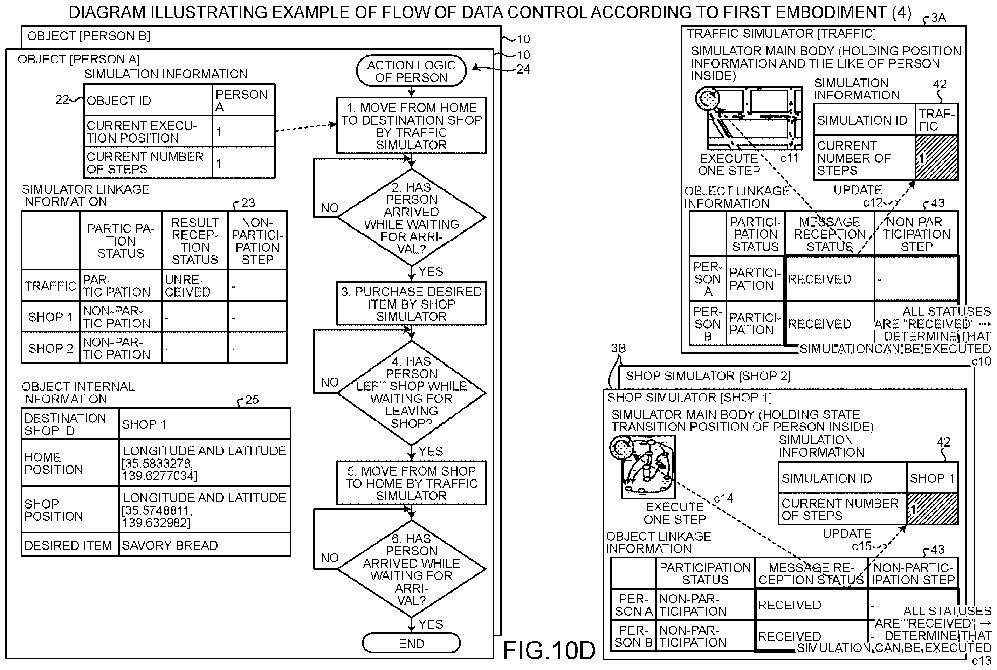

As illustrated in FIG. 10D, in the traffic simulator 3A and the shop simulators 3B of "shop 1" and "shop 2", if the reception statuses corresponding to all of the objects are "received", the execution determination unit 33 determines to execute the simulation. Herein, in the traffic simulator 3A, the message reception statuses corresponding to "person A" and "person B" in the object linkage information 43 are "received", so that the execution determination unit 33 determines that the simulation can be executed (c10). Thus, the simulator execution unit 34 executes one step (c11). Additionally, the simulator execution unit 34 updates the current number of steps of the simulation information 42 to "1" (c12).

In the shop simulator 3B of "shop 1", the message reception statuses corresponding to "person A" and "person B" in the object linkage information 43 are "received", so that the execution determination unit 33 determines that the simulation can be executed (c13). Thus, the simulator execution unit 34 executes one step (c14). Additionally, the simulator execution unit 34 updates the current number of steps of the simulation information 42 to "1" (c15). The shop simulator 3B of "shop 2" performs the same processing as that of the shop simulator 3B of "shop 1".

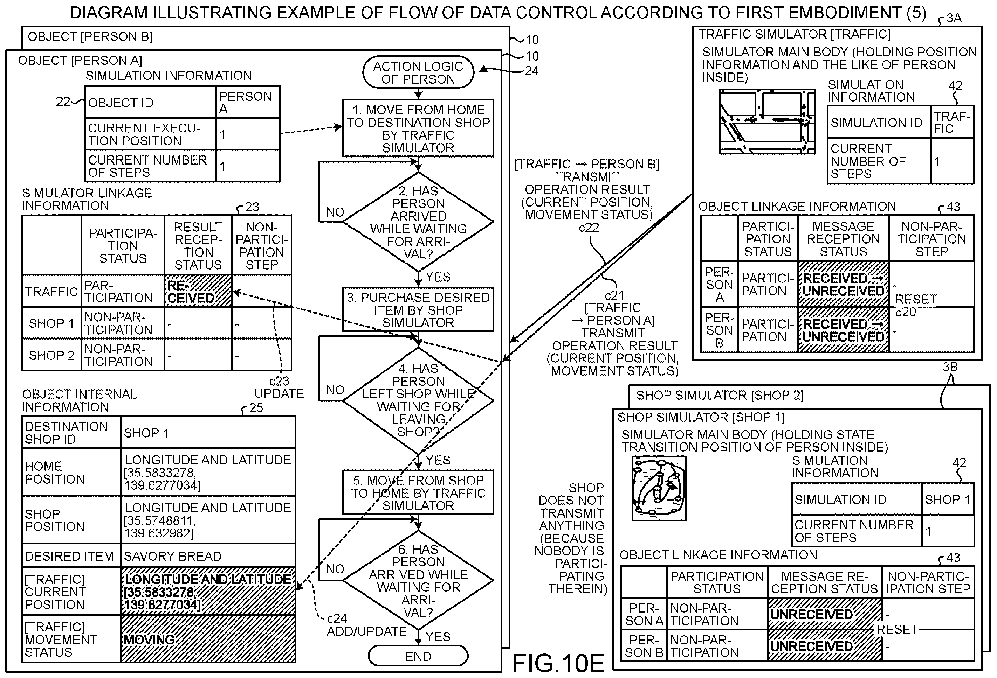

As illustrated in FIG. 10E, in the traffic simulator 3A, the transmission destination determination unit 35 determines the object the participation status of which is "participation" to be a transmission destination of a simulation result with reference to the object linkage information 43, and updates the reception status from "received" to "unreceived". Herein, the transmission destination determination unit 35 determines "person A" and "person B" the participation statuses of which are "participation" to be transmission destinations of the simulation result, and updates the message reception status from "received" to "unreceived" (c20).

In the traffic simulator 3A, the transmission unit 38 transmits the simulation result including the current position and the movement status to the object management unit 10 of "person A" as the transmission destination determined by the transmission destination determination unit 35 (c21). The transmission unit 38 also transmits the simulation result including the current position and the movement status to the object management unit 10 of "person B" as the transmission destination determined by the transmission destination determination unit 35 (c22). In the shop simulator 3B of "shop 1" and the shop simulator 3B of "shop 2", both objects of "person A" and "person B" are not participating, so that nothing is transmitted.

In the object management unit 10 of "person A", when receiving the simulation result from the participating traffic simulator 3A, the execution determination unit 12 updates the result reception status corresponding to the traffic simulator 3A in the simulator linkage information 23 to "received" (c23). Additionally, the execution determination unit 12 updates the current position and the movement status ("moving") included in the simulation result to the [traffic] current position and the [traffic] movement status in the object internal information 25 (c24). The object management unit 10 of "person B" performs the same processing as that of the object management unit 10 of "person A".

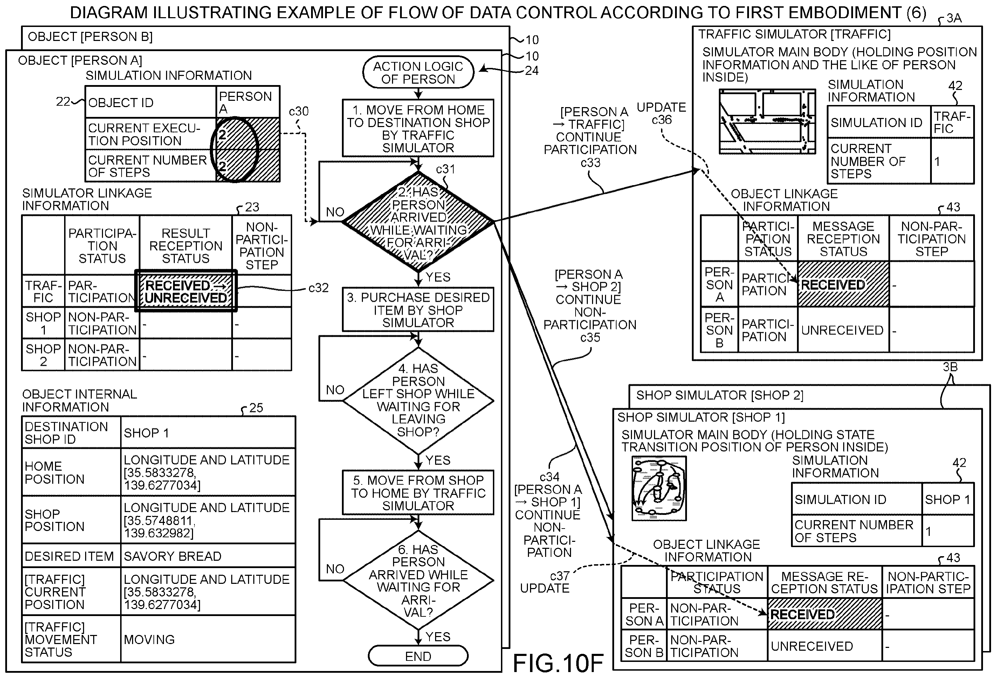

As illustrated in FIG. 10F, in the object management unit 10 of "person A", if result reception statuses corresponding to all of the participating simulators 3 are "received", the execution determination unit 12 determines to execute the next logic processing. Herein, the participating simulator 3 is only the traffic simulator 3A and the result reception status corresponding to the traffic simulator 3A is "received", so that the execution determination unit 12 determines to execute the next logic processing. That is, if the simulation result is received from the participating simulator 3, the execution determination unit 12 determines to execute the next logic processing without waiting for reception of the simulation result from the other simulator 3.

The logic execution unit 13 then updates, for the simulation information 22, the current execution position of the action logic from "1" to "2", and updates the current number of steps from "1" to "2" (c30). The logic execution unit 13 then executes the second logic processing of the action logic (c31). Herein, the second logic processing of "has person arrived while waiting for arrival?" is executed. The logic execution unit 13 then determines participation in the traffic simulator 3A based on an execution result of the logic processing, and updates the participation status corresponding to the traffic simulator 3A in the simulator linkage information 23 to "participation". Additionally, the transmission destination determination unit 14 determines the traffic simulator 3A the participation status of which is "participation" to be a transmission destination of a participation message with reference to the simulator linkage information 23, and updates the reception status to "unreceived" (c32). The transmission destination determination unit 14 also determines the shop simulators 3B of "shop 1" and "shop 2" the participation statuses of which are "non-participation" to be transmission destinations of the non-participation message with reference to the simulator linkage information 23.

The transmission unit 17 then transmits a participation continuation message to the traffic simulator 3A as the transmission destination determined by the transmission destination determination unit 14 (c33). The transmission unit 17 also transmits non-participation continuation messages to the shop simulators 3B of "shop 1" and "shop 2" as the transmission destinations determined by the transmission destination determination unit 14 (c34, c35).

In the traffic simulator 3A that has received the participation continuation message from the object management unit 10 of "person A", the participation status setting unit 32 updates the message reception status corresponding to "person A" in the object linkage information 43 to "received" (c36).

In the shop simulator 3B of "shop 1" that has received the non-participation continuation message from the object management unit 10 of "person A", the participation status setting unit 32 updates the message reception status corresponding to "person A" in the object linkage information 43 to "received" (c37). In the shop simulator 3B of "shop 2" that has received the non-participation continuation message from the object management unit 10 of "person A", the participation status setting unit 32 updates the message reception status corresponding to "person A" in the object linkage information 43 to "received".

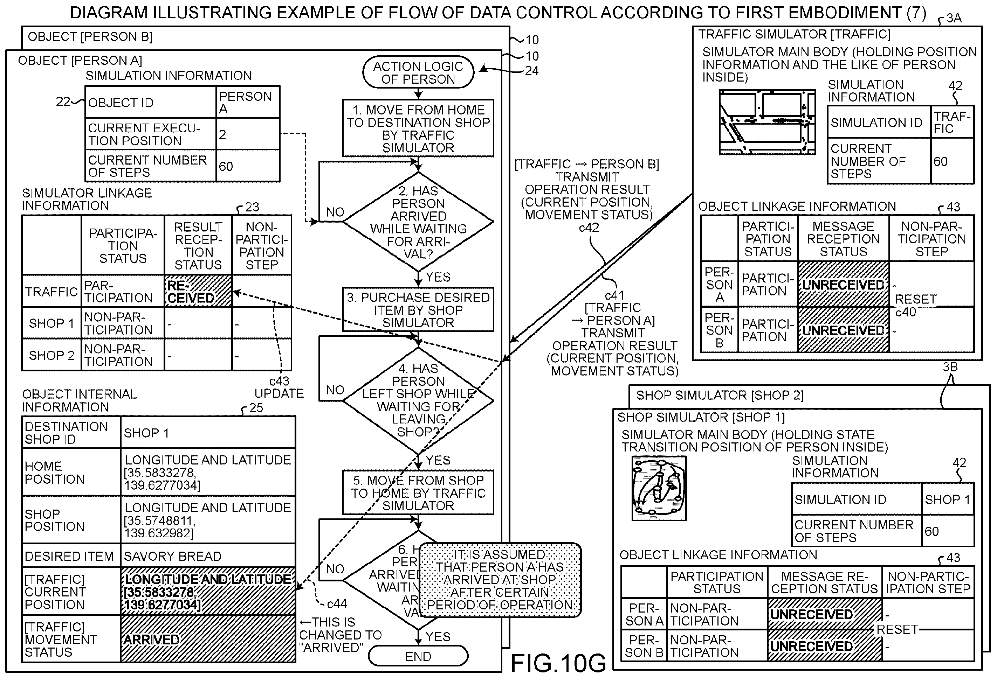

In FIG. 10G, it is assumed that the object of "person A" arrives at the shop after a certain period of operation. The current number of steps in the simulation information 22 and 42 is assumed to be "60".

In the traffic simulator 3A, the transmission destination determination unit 35 determines the object the participation status of which is "participation" to be the transmission destination of the simulation result with reference to the object linkage information 43, and updates the reception status to "unreceived". Herein, the transmission destination determination unit 35 determines "person A" and "person B" the participation statuses of which are "participation" to be the transmission destinations of the simulation result, and updates the message reception status to "unreceived" (c40).

In the traffic simulator 3A, the transmission unit 38 transmits the simulation result including the current position and the movement status ("arrived") to the object management unit 10 of "person A" as the transmission destination determined by the transmission destination determination unit 35 (c41). The transmission unit 38 also transmits the simulation result including the current position and the movement status to the object management unit 10 of "person B" as the transmission destination determined by the transmission destination determination unit 35 (c42). In the shop simulator 3B of "shop 1" and the shop simulator 3B of "shop 2", both objects of "person A" and "person B" are not participating, so that nothing is transmitted.

In the object management unit 10 of "person A", when receiving the simulation result from the participating traffic simulator 3A, the execution determination unit 12 updates the result reception status corresponding to the traffic simulator 3A in the simulator linkage information 23 to "received" (c43). Additionally, the execution determination unit 12 sets the current position and the movement status ("arrived") included in the simulation result to the [traffic] current position and the [traffic] movement status in the object internal information 25 (c44). Herein, "arrived" is set to the [traffic] movement status. The object management unit 10 of "person B" performs the same processing as that of the object management unit 10 of "person A"**.**

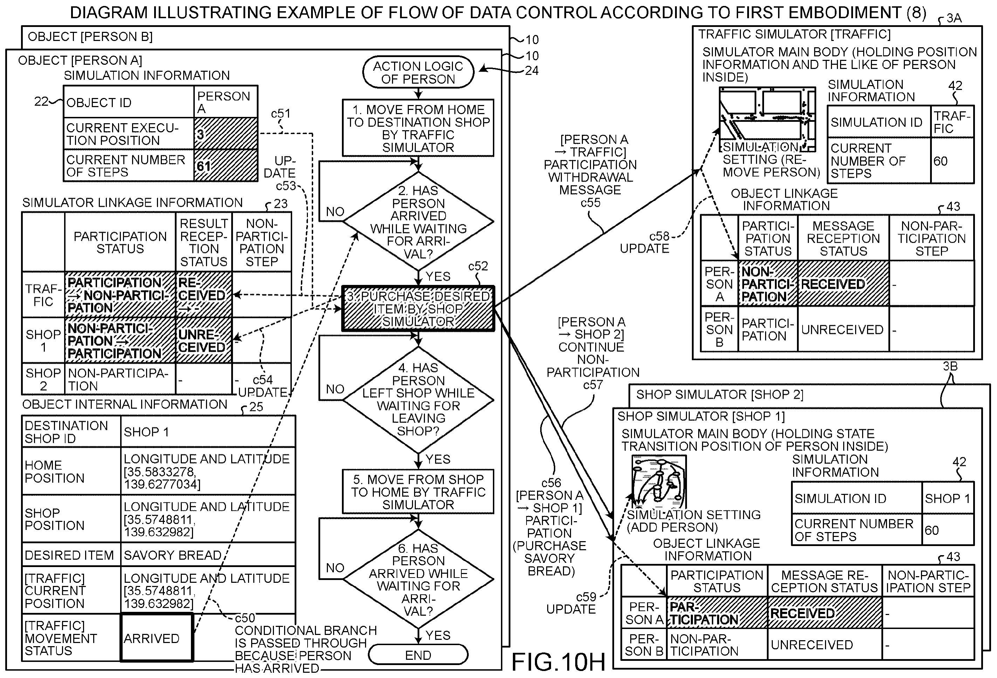

As illustrated in FIG. 10H, in the object management unit 10 of "person A"**,** if the result reception statuses corresponding to all of the participating simulators 3 are "received" and determination processing is satisfied when the current logic processing is the determination processing, the execution determination unit 12 determines to execute the next logic processing. Herein, the participating simulator 3 is only the traffic simulator 3A, and the result reception status corresponding to the traffic simulator 3A is "received". Additionally, the current logic processing is the determination processing of "has person arrived while waiting for arrival?", and the determination processing is satisfied because the movement status becomes "arrived" for "shop 1" as the destination. Thus, the execution determination unit 12 determines to execute the next logic processing (c50).

The logic execution unit 13 then updates, for the simulation information 22, the current execution position of the action logic from "2" to "3", and updates the current number of steps from "60" to "61" (c51). The logic execution unit 13 then executes the third logic processing of the action logic (c52). Herein, the second logic processing of "purchase desired item by shop simulator" is executed. The logic execution unit 13 then determines withdrawal from participation in the traffic simulator 3A based on an execution result of the logic processing, and updates the participation status corresponding to the traffic simulator 3A in the simulator linkage information 23 to "non-participation". Additionally, the transmission destination determination unit 14 determines the traffic simulator 3A the participation status of which is "non-participation" to be a transmission destination of a participation withdrawal message with reference to the simulator linkage information 23, and updates the reception status to "-" (c53).

The logic execution unit 13 also determines participation in the shop simulator 3B of "shop 1" indicating the destination shop based on the execution result of the logic processing, and updates the participation status corresponding to the shop simulator 3B of "shop 1" in the simulator linkage information 23 to "participation". The destination shop is set in the object internal information 25. Additionally, the transmission destination determination unit 14 determines the shop simulator 3B of "shop 1" the participation status of which is "participation" to be a transmission destination of the participation message with reference to the simulator linkage information 23, and updates the reception status to "unreceived" (c54).

The transmission unit 17 then transmits the participation withdrawal message to the traffic simulator 3A as the transmission destination determined by the transmission destination determination unit 14 (c55). The transmission unit 17 also transmits a participation message including information indicating that the desired item is "savory bread" to the shop simulator 3B of "shop 1" as the transmission destination determined by the transmission destination determination unit 14 (c56). The desired item is acquired from the object internal information 25. The transmission unit 17 transmits a non-participation continuation message to the shop simulator 3B of "shop 2" as the transmission destination determined by the transmission destination determination unit 14 (c57).

In the traffic simulator 3A that has received the participation withdrawal message from the object management unit 10 of "person A", the participation status setting unit 32 performs the following processing. The participation status setting unit 32 updates the participation status corresponding to "person A" in the object linkage information 43 to "non-participation", and updates the message reception status to "received" (c58).

In the shop simulator 3B of "shop 1" that has received the participation message from the object management unit 10 of "person A", the participation status setting unit 32 performs the following processing. The participation status setting unit 32 updates the participation status corresponding to "person A" in the object linkage information 43 to "participation", and updates the message reception status to "received" (c59). In the shop simulator 3B of "shop 2" that has received the non-participation continuation message from the object management unit 10 of "person A", the participation status setting unit 32 updates the message reception status corresponding to "person A" in the object linkage information 43 to "received".

In this manner, the object management unit 10 and the simulators 3 similarly repeat the operation until reaching the number of steps set as the number of simulation steps in the pieces of overall information 21 and 41 thereafter.

### <Flowchart of object management processing>

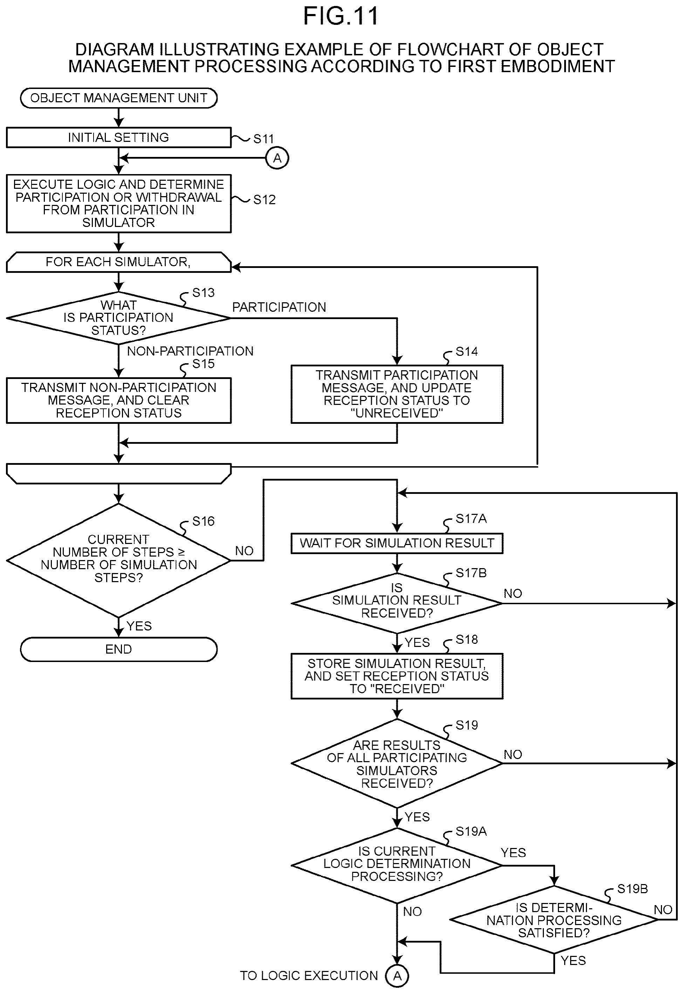

The following describes a flowchart of object management processing performed by the object management unit 10 with reference to FIG. 11. FIG. 11 is a diagram illustrating an example of the flowchart of the object management processing according to the first embodiment. It is assumed that the object management unit 10 has received an instruction to start simulation execution from the simulation execution management unit 5.

As illustrated in FIG. 11, the object management unit 10 that has received the instruction to start simulation execution performs initial setting (Step S11).

The object management unit 10 then executes the logic, and determines participation, non-participation, or withdrawal from participation in the simulator 3 based on an execution result (Step S12).

Subsequently, the object management unit 10 determines the participation status with reference to the simulator linkage information 23 for each simulator 3 (Step S13). If the participation status is "participation" (participation at Step S13), the object management unit 10 transmits the participation message to the relevant simulator 3, and updates the reception status of the simulator linkage information 23 to "unreceived" (Step S14).

On the other hand, if the participation status is "non-participation" (non-participation at Step S13), the object management unit 10 transmits a non-participation (or participation withdrawal) message to the relevant simulator 3, and clears the reception status of the simulator linkage information 23 (Step S15).

After completing determination of the participation status for each simulator 3, the object management unit 10 determines whether the current number of steps is equal to or larger than the number of simulation steps to determine the end (Step S16). For example, the object management unit 10 acquires the current number of steps from the simulation information 22. The object management unit 10 also acquires the number of simulation steps from the overall information 21. The object management unit 10 then determines whether the current number of steps is equal to or larger than the number of simulation steps.

If it is determined that the current number of steps is equal to or larger than the number of simulation steps (Yes at Step S16), the object management unit 10 ends the object management processing.

On the other hand, if it is determined that the current number of steps is smaller than the number of simulation steps (No at Step S16), the object management unit 10 waits for a simulation result from the simulator 3 (Step S17A). The object management unit 10 determines whether the simulation result has been received from the simulator 3 (Step S17B). If it is determined that the simulation result has not been received from the simulator 3 (No at Step S17B), the object management unit 10 repeats the determination processing until the simulation result is received.

On the other hand, if it is determined that the simulation result has been received from the simulator 3 (Yes at Step S17B), the object management unit 10 stores the simulation result in the object internal information 25. Additionally, the object management unit 10 sets the reception status of the simulator linkage information 23 to "received" (Step S18).

The object management unit 10 then determines whether results of all of the participating simulators 3 are received (Step S19). If it is determined that the results of all of the participating simulators 3 are not received (No at Step S19), the object management unit 10 advances the process to Step S17A to receive the next simulation result.

On the other hand, if it is determined that the results of all of the participating simulators 3 are received (Yes at Step S19), the object management unit 10 determines whether current logic is determination processing (Step S19A). If it is determined that the current logic is not the determination processing (No at Step S19A), the object management unit 10 advances the process to Step S12 to execute the next logic.

On the other hand, if it is determined that the current logic is the determination processing (Yes at Step S19A), the object management unit 10 determines whether the determination processing is satisfied with reference to the object internal information 25 (Step S19B). If it is determined that the determination processing is not satisfied (No at Step S19B), the object management unit 10 advances the process to Step S17A to receive the next simulation result.

On the other hand, if it is determined that the determination processing is satisfied (Yes at Step S19B), the object management unit 10 advances the process to Step S12 to execute the next logic.

### <Flowchart of simulator management processing>

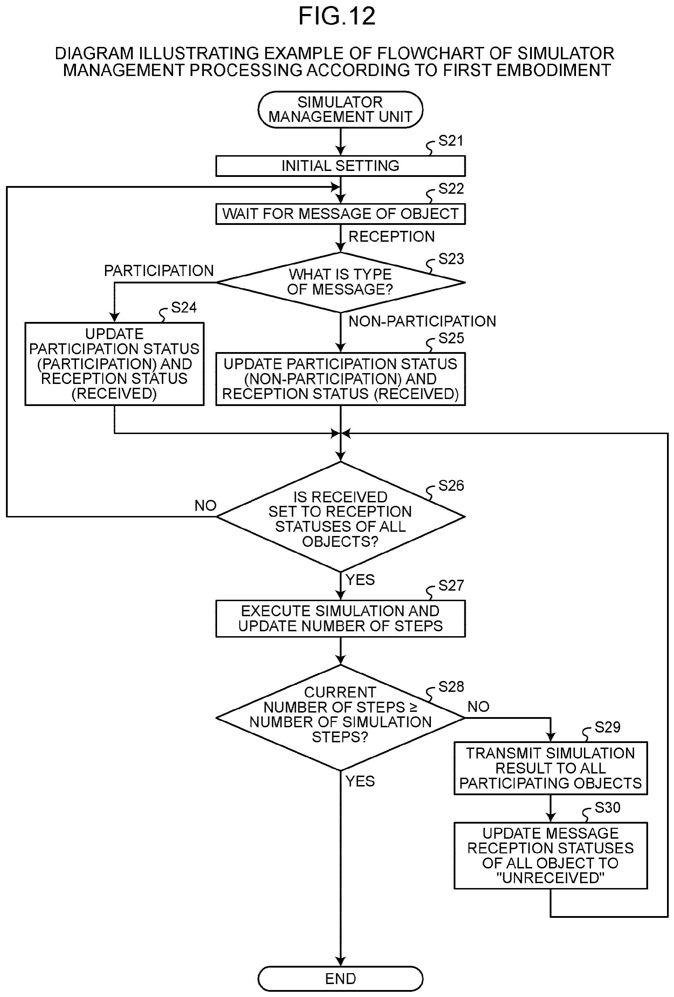

The following describes a flowchart of simulator management processing performed by the simulator management unit 30 with reference to FIG. 12. FIG. 12 is a diagram illustrating an example of the flowchart of the simulator management processing according to the first embodiment. It is assumed that the simulator management unit 30 has received an instruction to start simulation execution from the simulation execution management unit 5.

As illustrated in FIG. 12, the simulator management unit 30 that has received the instruction to start simulation execution performs initial setting (Step S21).

The simulator management unit 30 waits for a message of the object transmitted from the object management unit 10 (Step S22). When receiving the message, the simulator management unit 30 determines a type of the message (Step S23). If the type of the message is determined to be "participation" (participation at Step S23), the simulator management unit 30 updates the participation status of the object linkage information 43 to "participation", and updates the reception status to "received" (Step S24). The simulator management unit 30 then advances the process to Step S26.

If the type of the message is determined to be "non-participation" (or withdrawal from participation) (non-participation at Step S23), the simulator management unit 30 updates the participation status of the object linkage information 43 to "non-participation", and updates the reception status to "received" (Step S25). The simulator management unit 30 then advances the process to Step S26.

At Step S26, the simulator management unit 30 determines whether "received" is set to the reception statuses of all objects (Step S26). If it is determined that "received" is not set to the reception statuses of all objects (No at Step S26), the simulator management unit 30 advances the process to Step S22 to wait for the next message.

On the other hand, if it is determined that "received" is set to the reception statuses of all objects (Yes at Step S26), the simulator management unit 30 executes the simulation, and updates the current number of steps of the simulation information 42 (Step S27).

The simulator management unit 30 then determines whether the current number of steps is equal to or larger than the number of simulation steps to determine the end (Step S28). For example, the simulator management unit 30 acquires the current number of steps from the simulation information 22. The simulator management unit 30 acquires the number of simulation steps from the overall information 21. The simulator management unit 30 then determines whether the current number of steps is equal to or larger than the number of simulation steps.

If it is determined that the current number of steps is equal to or larger than the number of simulation steps (Yes at Step S28), the simulator management unit 30 ends the simulator management processing.

On the other hand, if it is determined that the current number of steps is smaller than the number of simulation steps (No at Step S28), the simulator management unit 30 transmits simulation results to all participating objects (Step S29). The simulator management unit 30 then updates message reception statuses of all objects in the object linkage information 43 to "unreceived" (Step S30). The simulator management unit 30 then advances the process to Step S26.

### <Flowchart of simulation execution management processing>

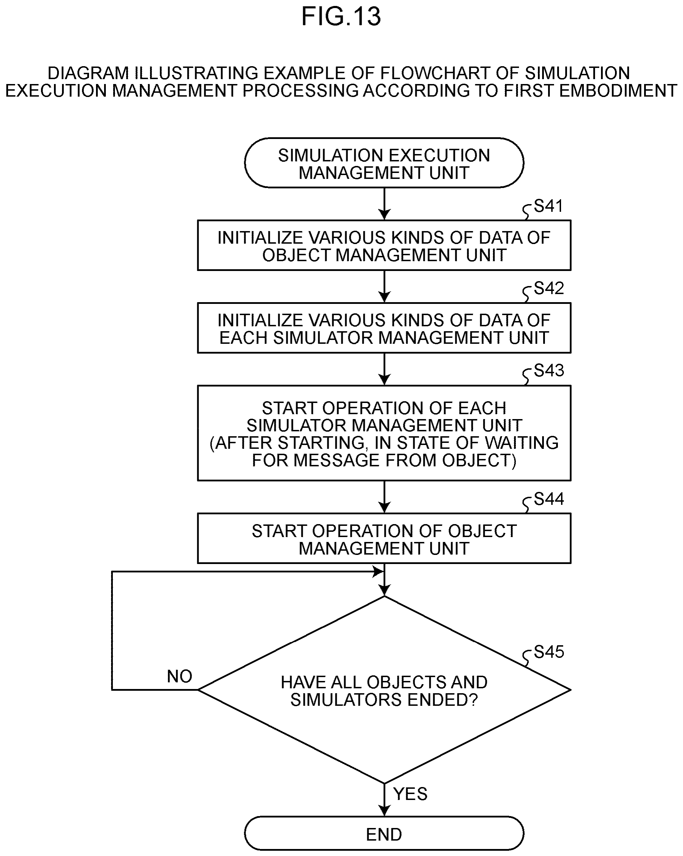

The following describes a flowchart of simulation execution management processing performed by the simulation execution management unit 5 with reference to FIG. 13. FIG. 13 is a diagram illustrating an example of the flowchart of the simulation execution management processing according to the first embodiment. It is assumed that the simulation execution management unit 5 has received a start instruction from the system administrator.

The simulation execution management unit 5 initializes various kinds of data of the object management unit 10 (Step S41). The simulation execution management unit 5 initializes various kinds of data of each simulator management unit 30 (Step S42).

The simulation execution management unit 5 then starts operation of each simulator management unit 30 (Step S43). Subsequently, each simulator management unit 30 is caused to be in a state of waiting for a message from the object management unit 10. The simulation execution management unit 5 then starts operation of the object management unit 10 (Step S44).

The simulation execution management unit 5 then determines whether all of the object management units 10 and simulator management units 30 have ended (Step S45). If it is determined that all of the object management units 10 and simulator management units 30 have not ended (No at Step S45), the simulation execution management unit 5 repeats the determination processing until all of the object management units 10 and simulator management units 30 end.

On the other hand, if it is determined that all of the object management units 10 and simulator management units 30 have ended (Yes at Step S45), the simulation execution management unit 5 ends the simulation execution management processing.

### <Effect of first embodiment>

According to the first embodiment described above, when the pieces of data are linked among the simulators 3, the object management unit 10 successively executes the logic based on the action logic that describes action of the target (object). When the fact that the target has moved to a predetermined position is notified from a first simulator 3 in accordance with execution of specific logic, the object management unit 10 determines to which of a second simulator 3 and a third simulator 3 data of the target is to be transmitted using an attribute of the target stored in advance. The object management unit 10 then transmits the data of the target to the simulator 3 to which the data of the target is determined to be transmitted. With such a configuration, the object management unit 10 links pieces of data among the simulators 3 using the action logic. Due to this, control in a case in which a plurality of transmission destinations are present is not necessarily set to the simulator 3, so that work of updating the control and the like are facilitated.

According to the first embodiment described above, the object management unit 10 transmits, to the first simulator 3, participation in the first simulator 3 in accordance with content of the logic, and holds the participation in the participation status for the first simulator 3 of a participation status storage unit that stores therein the participation status of the target for each simulator 3. When the fact that the target has moved to the predetermined position is notified from the first simulator, if simulator results are notified from all simulators 3 in which participation is hold in the participation status, the object management unit 10 executes the next logic. With such a configuration, the object management unit 10 can efficiently advance the logic of the target by advancing the logic without waiting for a notification from the non-participating simulator 3. Second embodiment

As described above, in the data control device 1 according to the first embodiment, the object management unit 10 executes the next logic processing if the result reception statuses corresponding to all of the participating simulators 3 are "received". That is, if the simulation result is received from the participating simulator 3 for the object as a target, the object management unit 10 executes the next logic processing without waiting for reception of the simulation result from the non-participating simulator 3. However, the object management unit 10 is not limited thereto, and may determine non-participation in the simulator 3 and a non-participation period based on a predetermined method, and notify the non-participation period to the simulator 3 determined to be non-participation. The simulator 3 that has received the notification may perform the next simulation step without waiting for reception of a message from the object management unit 10 only in the non-participation period.

Thus, in the second embodiment, the object management unit 10 determines non-participation in the simulator 3 and the non-participation period based on a predetermined method, and notifies the non-participation period to the simulator 3 determined to be non-participation. The following describes a case in which the simulator 3 that has received the notification performs the next simulation step without waiting for reception of a message from the object management unit 10 only in the non-participation period.

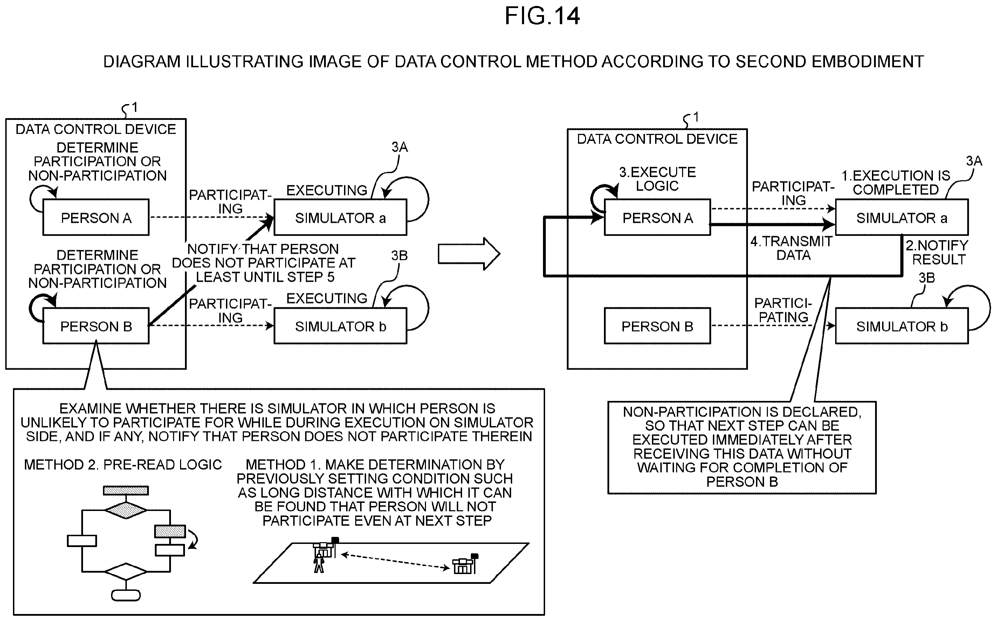

The following describes an image of a data control method according to the second embodiment with reference to FIG. 14. FIG. 14 is a diagram illustrating an image of the data control method according to the second embodiment. In FIG. 14, the target is assumed to be a person, and the simulators 3 are assumed to be the simulator a (3A) and the simulator b (3B).

As illustrated in a left figure of FIG. 14, the object management unit 10 of "person A" executes the logic based on the logic (behavior) associated with the person A, and is participating in the simulator a (3A) in accordance with an execution result. The object management unit 10 of "person B" executes the logic based on the logic (behavior) associated with the person B, and is participating in the simulator b (3B) in accordance with an execution result.

The object management unit 10 of "person B" also examines whether there is the simulator 3 in which the object management unit 10 of "person B" is unlikely to participate for a while based on a predetermined method, and if any, notifies the simulator 3 that the object management unit 10 of "person B" does not participate therein for the non-participation period. Herein, the object management unit 10 of "person B" notifies that the object management unit 10 of "person B" does not participate in the simulator a (3A) at least until Step "5".

As illustrated in a right figure of FIG. 14, the simulator a (3A), which has received the notification that the object management unit 10 of "person B" does not participate therein at least until Step "5" from the object management unit 10 of "person B", executes the next simulation step after receiving the message from the object management unit 10 of "person A" without waiting for reception of the message from the object management unit 10 of "person B" until Step "5". The simulator a (3A) then notifies the simulation result to the object management unit 10 of "person A".

Herein, the predetermined method may be a case of acquiring non-participation in a specific simulator 3 and a non-participation period using a non-participation rule determined in advance (method 1). The predetermined method may be a case of acquiring non-participation in the specific simulator 3 and the non-participation period by pre-reading the logic associated with the object (method 2).

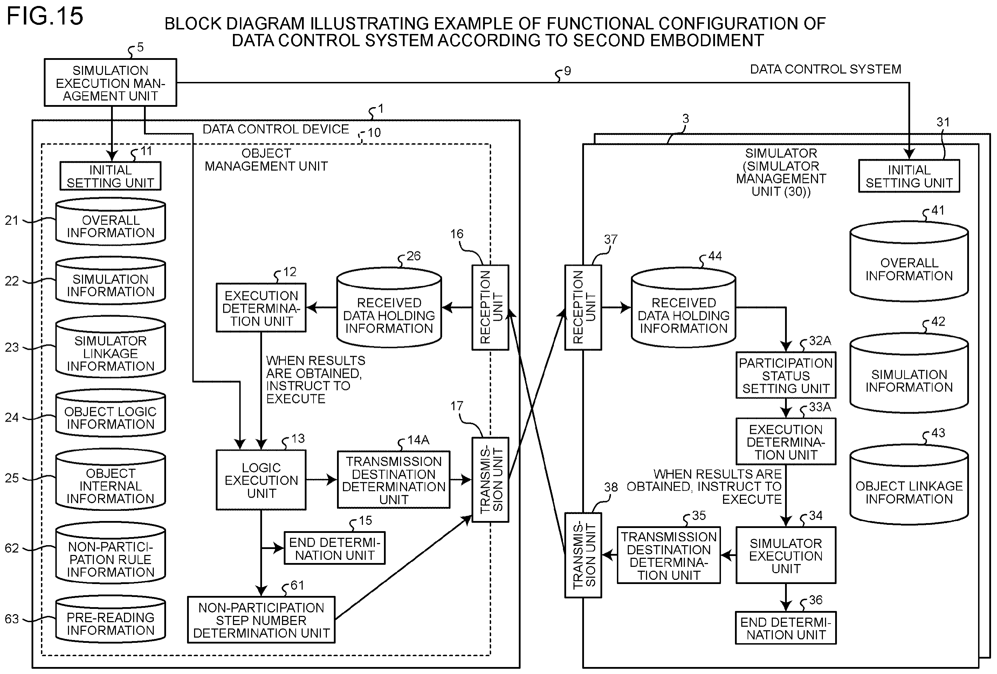

FIG. 15 is a block diagram illustrating an example of a functional configuration of the data control system according to the second embodiment. Regarding the functional configuration of the data control system 9 according to the second embodiment, the same configuration as that of the data control system 9 illustrated in FIG. 1 is denoted by the same reference numeral, and redundant description of the configuration and operation will not be repeated. The second embodiment is different from the first embodiment in that a non-participation step number determination unit 61, non-participation rule 62, and pre-reading information 63 are added to the object management unit 10. The second embodiment is further different from the first embodiment in that the transmission destination determination unit 14 is changed to a transmission destination determination unit 14A. Additionally, the second embodiment is different from the first embodiment in that the participation status setting unit 32 and the execution determination unit 33 of the simulator 3 are changed to a participation status setting unit 32A and an execution determination unit 33A.

The non-participation step number determination unit 61 determines the number of non-participation steps for the simulator 3. For example, the non-participation step number determination unit 61 determines non-participation in some of the simulators 3 and the number of non-participation steps (non-participation period) based on a predetermined method. The non-participation step number determination unit 61 then notifies, via the transmission unit 17, the determined simulator 3 of a non-participation message indicating non-participation for the number of non-participation steps. The non-participation step number determination unit 61 then sets the determined number of non-participation steps to the non-participation step for the relevant simulator 3 in the simulator linkage information 23.

The transmission destination determination unit 14A determines the transmission destination. For example, with reference to the simulator linkage information 23, the transmission destination determination unit 14A determines the simulator 3 the participation status of which is "participation" to be the transmission destination of a message indicating participation, and sets the reception status to "unreceived". The transmission destination determination unit 14A also determines, to be the simulator 3 to which the message is not transmitted, the simulator 3 the participation status of which is "non-participation" and the current number of steps of which is equal to or smaller than the non-participation step with reference to the simulator linkage information 23 and the simulation information 22. Additionally, the transmission destination determination unit 14A determines the other simulator 3 the participation status of which is "non-participation" to be the transmission destination of the message indicating non-participation, and sets the reception status and the non-participation step to be **"-"** to be cleared. That is, the transmission destination determination unit 14A determines, to be the transmission destination of the message indicating non-participation, the simulator 3 the participation status of which is "non-participation" and the non-participation step of which is not set, or the simulator 3 the participation status of which is "non-participation" and the current number of steps of which exceeds the non-participation step.

The participation status setting unit 32A sets the participation status for the object. For example, the participation status setting unit 32A waits for various messages from the object management unit 10. When receiving a message indicating participation from the object management unit 10, the participation status setting unit 32A sets the participation status corresponding to the relevant object in the object linkage information 43 to "participation", and sets the message reception status to "received". When receiving a message indicating non-participation from the object management unit 10, the participation status setting unit 32A sets the participation status corresponding to the relevant object in the object linkage information 43 to "non-participation", and sets the message reception status to "received". When receiving a non-participation message indicating non-participation for the number of non-participation steps from the object management unit 10, the participation status setting unit 32A sets the non-participation step corresponding to the relevant object in the object linkage information 43 to the received number of non-participation steps.

The execution determination unit 33A determines execution of the simulation. For example, if the reception statuses corresponding to all of the objects are "received", the execution determination unit 33A determines to execute the simulation. If the reception statuses corresponding to all of the objects are not "received", the execution determination unit 33A determines to execute the simulation when the non-participation step corresponding to the object the reception status of which is not "received" is equal to or larger than the current number of steps. Due to this, even if the reception statuses corresponding to some of the objects are not "received", the execution determination unit 33A can execute the next simulation step without waiting for reception for the non-participation step, so that a waiting time can be shortened.

### <Example of determining number of non-participation steps>

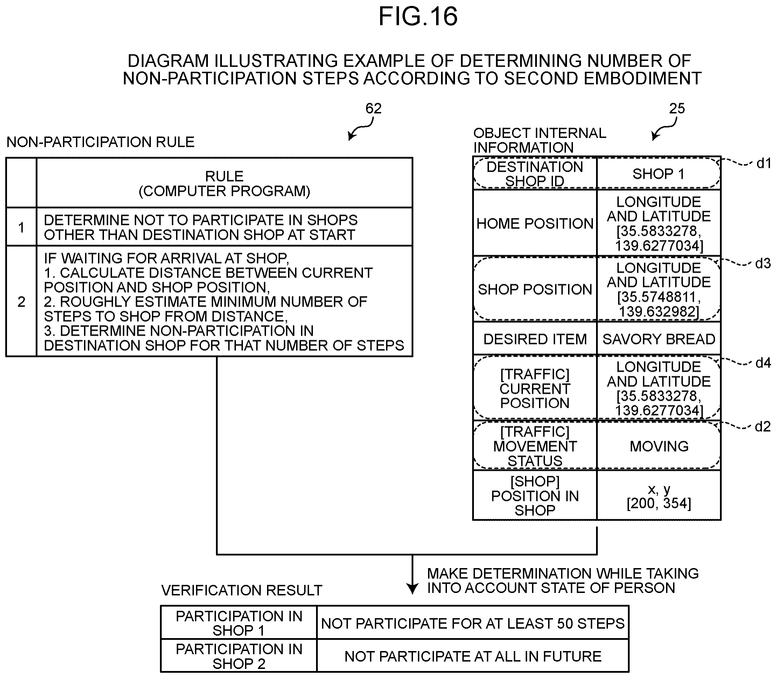

FIG. 16 is a diagram illustrating an example of determining the number of non-participation steps according to the second embodiment. The example of FIG. 16 is a case of determining the number of non-participation steps using the non-participation rule 62 (method 1). The non-participation rule 62 may be created in advance by a simulation designer. For example, the simulation designer creates the non-participation rule 62 indicating a condition for not participating in the simulator 3 by a computer program using internal information (25) of the object.

In the example illustrated in FIG. 16, in the non-participation rule 62, "determine not to participate in shops other than destination shop at start" is set as a rule 1. That is, such a rule indicates that the object participates only in the destination shop, and does not participate in the other shops. The non-participation step number determination unit 61 determines non-participation in the shop simulators (3) other than the destination shop with reference to the destination shop ID (d1) in the object internal information 25 based on the rule 1 of the non-participation rule 62. At this point, the non-participation step number determination unit 61 determines the number of non-participation steps as the number of simulation steps in the overall information 21.

In the non-participation rule 62, as a rule 2, "if waiting for arrival at shop, 1. calculate distance between current position and shop position, 2. roughly estimate minimum number of steps to shop from distance, 3. determine non-participation in destination shop for that number of steps" is set. The non-participation step number determination unit 61 refers to the movement status, the current position, and the shop position in the object internal information 25, and if the movement status (d2) is "moving", calculates the minimum number of steps from the current position (d4) and the shop position (d3) based on the rule 2 of the non-participation rule 62. The non-participation step number determination unit 61 then determines non-participation in the shop simulator (3) of the destination shop for the calculated minimum number of steps.

### <Another example of determining number of non-participation steps>

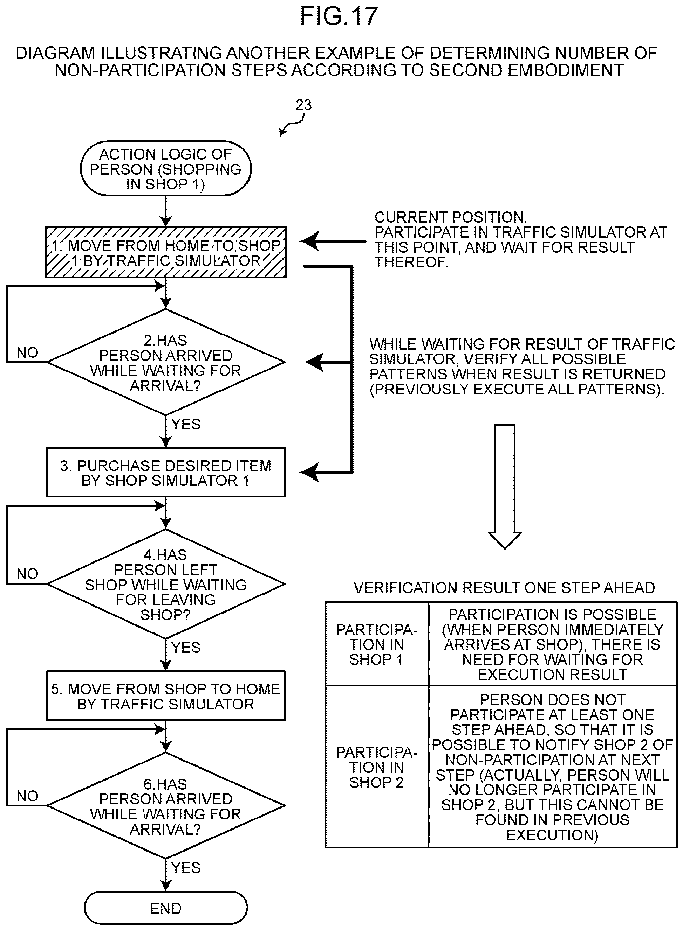

FIG. 17 is a diagram illustrating another example of determining the number of non-participation steps according to the second embodiment. The example of FIG. 17 is a case of determining the number of non-participation steps by pre-reading the logic associated with the object (method 2). FIG. 17 represents the object logic information 24 (abbreviated as the logic) of "go to shop 1 for shopping". For example, the current execution position of the simulation information 22 is assumed to be "1". That is, the object management unit 10 executes "move from home to shop 1 by traffic simulator". Accordingly, the object management unit 10 participates in the traffic simulator 3A, and waits for a simulation result. The non-participation step number determination unit 61 of the object management unit 10 verifies, using the logic, possible patterns when the simulation result is returned while waiting for the simulation result. Herein, a verification result of one step (for example, one second) ahead is as follows. For "shop 1", there is a need for waiting for the simulation result because there is a possibility of waiting for arrival of the simulation result or a possibility of arrival at the shop (there is a possibility of participation). For "shop 2", the object management unit 10 does not participate therein at least one logic processing ahead, so that a notification of non-participation at the next step can be made. In this manner, the non-participation step number determination unit 61 verifies possible patterns one step ahead, two steps ahead, and the like of logic execution at the current execution position, and determines the non-participating simulator 3 and the number of non-participation steps.

### <Specific example of non-participation rule>

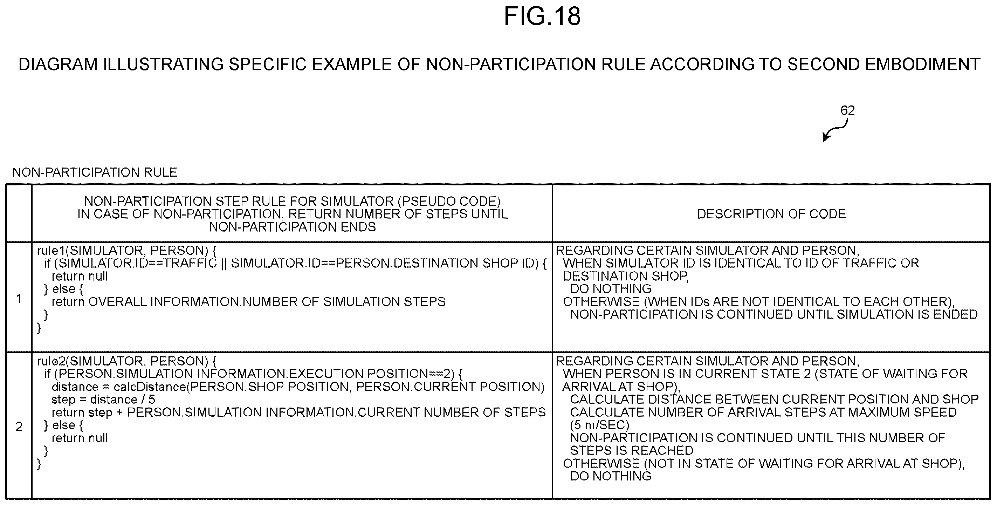

FIG. 18 is a diagram illustrating a specific example of a non-participation rule according to the second embodiment. In a rule 1 in the non-participation rule 62 illustrated in FIG. 18, for each simulator 3, it is indicated that "do nothing if ID of simulator 3 is ID of traffic simulator or destination shop ID associated with "person" indicated by object ID". On the other hand, it is indicated that "if ID of simulator 3 is not ID of traffic simulator and is not destination shop ID associated with "person" indicated by object ID, this simulator 3 will not participate until reaching number of simulation steps described in overall information 21".

In a rule 2 in the non-participation rule 62 illustrated in FIG. 18, for each simulator 3, it is indicated that "if waiting for arrival at shop, 1. calculate distance between shop position and current position, 2. roughly estimate minimum number of steps to shop from distance, 3. determine non-participation in destination step for that number of steps".

### <Example of data control>

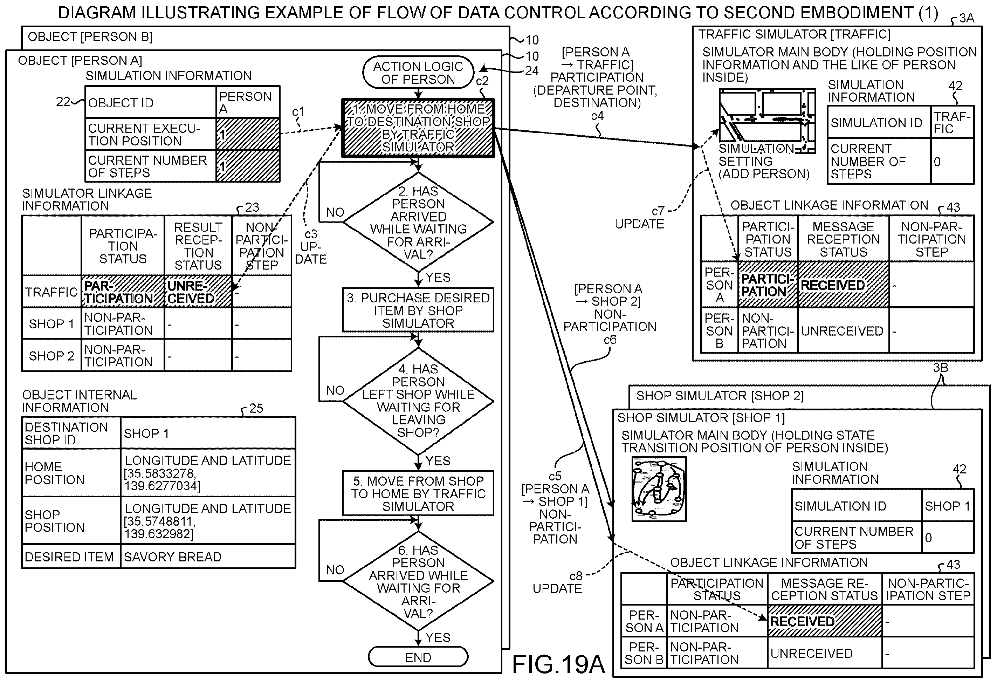

The following describes an example of data control according to the second embodiment with reference to FIG. 19A to FIG. 19L. FIG. 19A to FIG. 19L are diagrams illustrating an example of a flow of data control according to the second embodiment. Herein, it is assumed that the non-participation rule 62 is applied to the non-participation step number determination unit 61. Additionally, the following describes a scene in which the object indicated by "person A" moves to "shop 1" to purchase "savory bread", and the object indicated by "person B" moves to "shop 2" to purchase "vegetable".

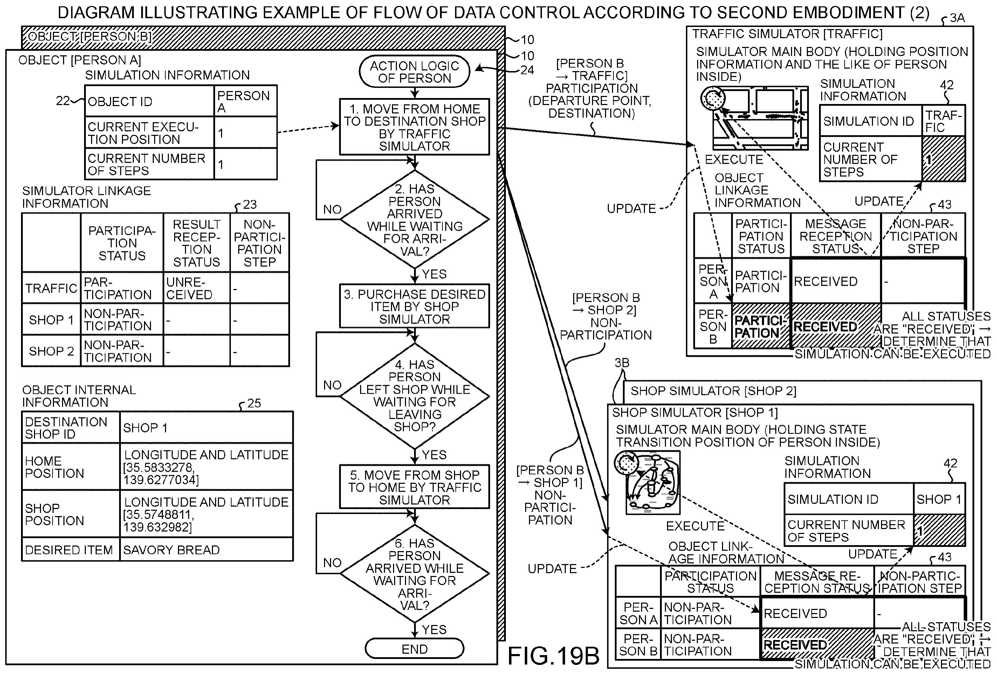

In FIG. 19A and FIG. 19B, c1 to c8 are the same pieces of processing as those in FIG. 10B and FIG. 10C, so that they are denoted by the same reference numerals. As illustrated in FIG. 19A, for the object management unit 10 of "person A", the logic execution unit 13 receives an instruction to start simulation execution from the simulation execution management unit 5. The logic execution unit 13 then sets, for the simulation information 22, the current execution position of the action logic to "1", sets the current number of steps to "1" (c1), and executes the first logic processing of the action logic (c2). Herein, the first logic processing of "move from home to destination shop by traffic simulator" is executed. The logic execution unit 13 then determines participation in the traffic simulator 3A based on an execution result of the logic processing. The logic execution unit 13 then sets the participation status corresponding to the traffic simulator 3A in the simulator linkage information 23 to "participation". Additionally, the transmission destination determination unit 14 determines the traffic simulator 3A the participation status of which is "participation" to be a transmission destination of a participation message with reference to the simulator linkage information 23, and sets the reception status to "unreceived" (c3). The transmission destination determination unit 14A determines the shop simulators 3B of "shop 1" and "shop 2" the participation statuses of which are "non-participation" to be transmission destinations of a non-participation message with reference to the simulator linkage information 23, and sets the reception status to "-" to be cleared.

The transmission unit 17 transmits a participation message including a departure point and a destination to the traffic simulator 3A as the transmission destination determined by the transmission destination determination unit 14 (c4). Herein, the departure point is home and the destination is "shop 1". The departure point and the destination are set in the object internal information 25. The transmission unit 17 transmits non-participation messages to the shop simulators 3B of "shop 1" and "shop 2" as transmission destinations determined by the transmission destination determination unit 14 (c5, c6).

In the traffic simulator 3A that has received the participation message from the object management unit 10 of "person A", the participation status setting unit 32A sets the participation status corresponding to "person A" in the object linkage information 43 to "participation", and sets the message reception status to "received" (c7). The traffic simulator 3A then adds "person A" to a simulation main body, and holds position information of the departure point and the destination of "person A" in the simulation main body.

In the shop simulator 3B of "shop 1" that has received the non-participation message from the object management unit 10 of "person A", the participation status setting unit 32A sets the participation status corresponding to "person A" in the object linkage information 43 to "non-participation", and sets the message reception status to "received" (c8). In the shop simulator 3B of "shop 2" that has received the non-participation message from the object management unit 10 of "person A", the participation status setting unit 32 sets the participation status corresponding to "person A" in the object linkage information 43 to "non-participation", and sets the message reception status to "received".

As illustrated in FIG. 19B, for the object management unit 10 of "person B", the logic is executed similarly to the case of the object management unit 10 of "person A". As a result, the simulator linkage information 23 becomes the same as a result illustrated in FIG. 19A.

In the traffic simulator 3A, the participation status setting unit 32A sets the participation status corresponding to "person B" in the object linkage information 43 to "participation", and sets the message reception status to "received". The traffic simulator 3A then adds "person B" to the simulation main body, and holds position information of the departure point and the destination of "person B" in the simulation main body. In the shop simulator 3B of "shop 1", the participation status setting unit 32A sets the participation status corresponding to "person B" in the object linkage information 43 to "non-participation", and sets the message reception status to "received". In the shop simulator 3B of "shop 2", the participation status setting unit 32A sets the participation status corresponding to "person B" in the object linkage information 43 to "non-participation", and sets the message reception status to "received".

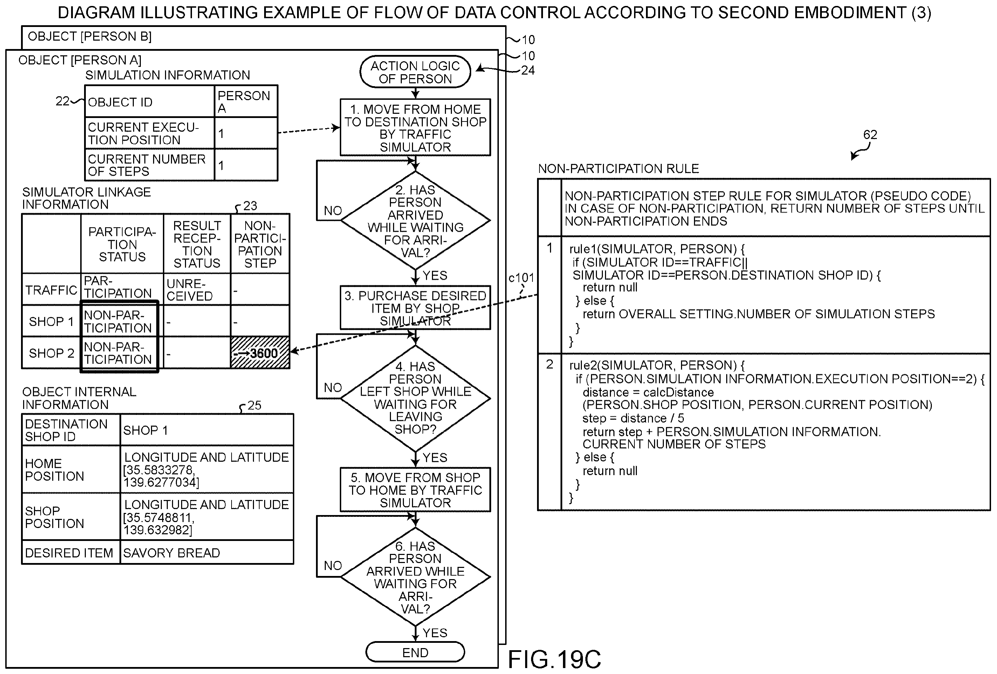

As illustrated in FIG. 19C, for the object management unit 10 of "person A", the non-participation step number determination unit 61 applies the non-participation rule 62 to each simulator 3 of "non-participation" while waiting for a simulation result. That is, the non-participation step number determination unit 61 determines whether there is the simulator 3 to be non-participation without receiving the simulation result. For example, the non-participation step number determination unit 61 determines non-participation in the shop simulators 3B other than the destination shop with reference to the destination shop ID in the object internal information 25 based on the rule 1 of the non-participation rule 62. Herein, the destination shop ID in the object internal information 25 is "shop 1", so that non-participation in the shop simulator 3B indicated by "shop 2" other than "shop 1" is determined. At this point, the non-participation step number determination unit 61 determines the number of non-participation steps as the number of simulation steps in the overall information 21. Herein, the number of simulation steps in the overall information 21 is "3600", so that the non-participation step number determination unit 61 updates the non-participation step corresponding to "shop 2" in the simulator linkage information 23 from "-" to "3600" (c101). As a result, "shop 2" matches the rule 1 of the non-participation rule 62, so that the object management unit 10 of "person A" does not participate in the shop simulator 3B of "shop 2" until the set "3600" steps are reached. The non-participation step number determination unit 61 is not in a state of waiting for arrival (moving) yet, so that it does not match the rule 2 of the non-participation rule 62.

For the object management unit 10 of "person B", the non-participation step number determination unit 61 similarly updates the non-participation step corresponding to "shop 1" in the simulator linkage information 23 from "-" to "3600".

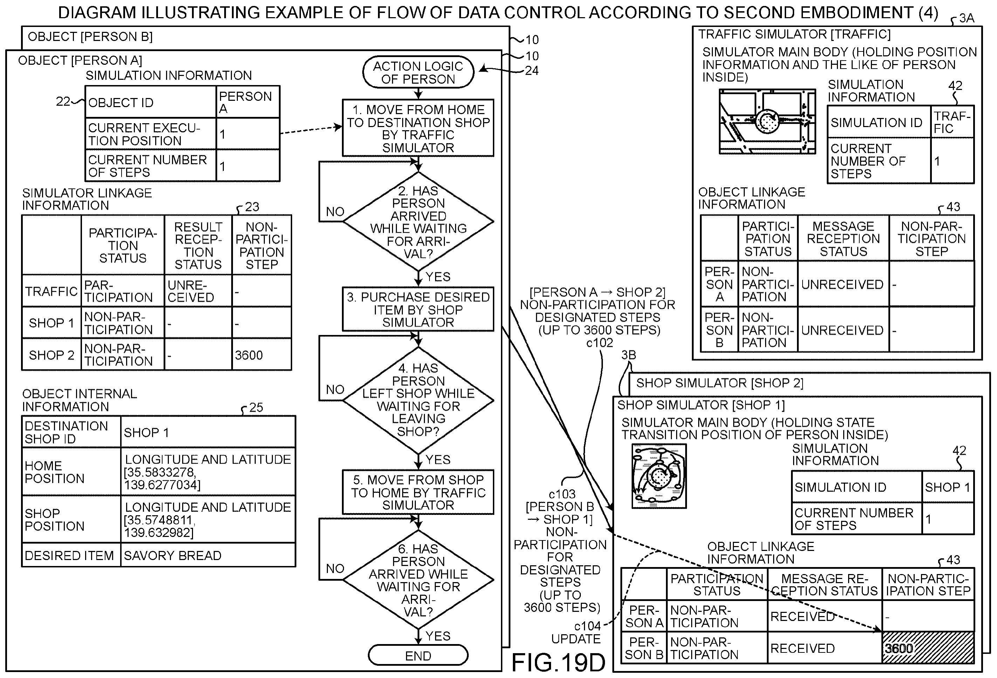

As illustrated in FIG. 19D, for the object management unit 10 of "person A", the non-participation step number determination unit 61 notifies, via the transmission unit 17, the shop simulator 3B of "shop 2" of a non-participation message indicating non-participation for the number of non-participation steps "3600" (c102). Similarly, for the object management unit 10 of "person B", the non-participation step number determination unit 61 notifies, via the transmission unit 17, the shop simulator 3B of "shop 1" of a non-participation message indicating non-participation for the number of non-participation steps "3600" (c103).

In the shop simulator 3B of "shop 1", the participation status setting unit 32A updates the non-participation step corresponding to "person B" in the object linkage information 43 to "3600" (c104). Similarly, in the shop simulator 3B of "shop 2", the participation status setting unit 32A updates the non-participation step corresponding to "person A" in the object linkage information 43 to "3600".

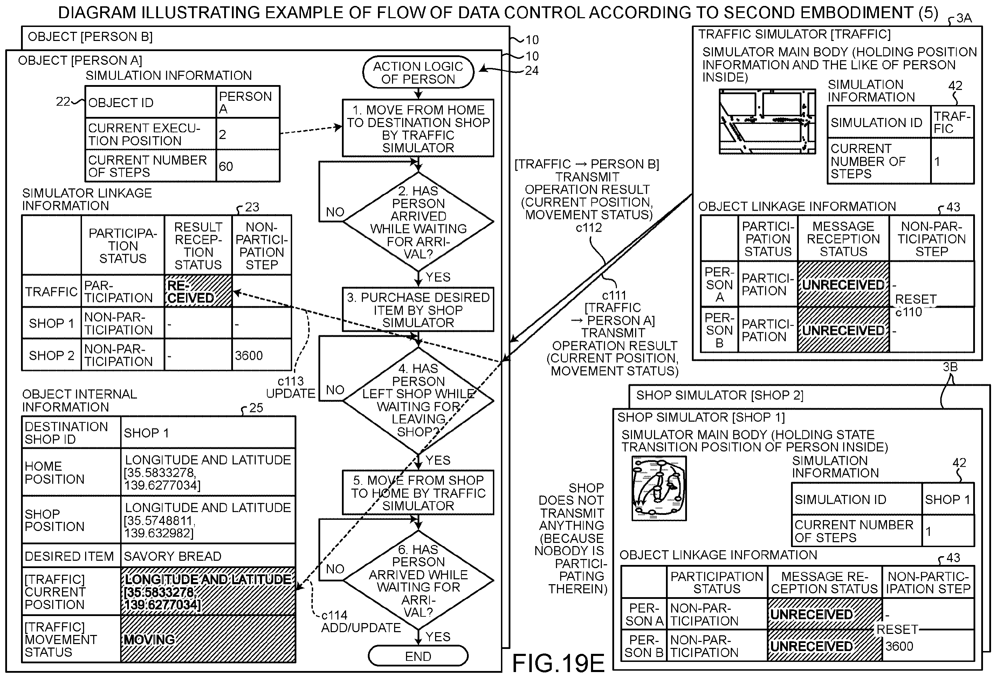

Processing in FIG. 19E is the same as the processing in FIG. 10E. As illustrated in FIG. 19E, in the traffic simulator 3A, the transmission destination determination unit 35 determines the object the participation status of which is "participation" to be a transmission destination of a simulation result with reference to the object linkage information 43, and updates the reception status from "received" to "unreceived". Herein, the transmission destination determination unit 35 determines "person A" and "person B" the participation statuses of which are "participation" to be transmission destinations of the simulation result, and updates the message reception status from "received" to "unreceived" (c110).

In the traffic simulator 3A, the transmission unit 38 transmits the simulation result including the current position and the movement status to the object management unit 10 of "person A" as the transmission destination determined by the transmission destination determination unit 35 (c111). The transmission unit 38 also transmits the simulation result including the current position and the movement status to the object management unit 10 of "person B" as the transmission destination determined by the transmission destination determination unit 35 (c112). In the shop simulator 3B of "shop 1" and the shop simulator 3B of "shop 2", both objects of "person A" and "person B" are not participating, so that nothing is transmitted.

In the object management unit 10 of "person A", when receiving the simulation result from the participating traffic simulator 3A, the execution determination unit 12 updates the result reception status corresponding to the traffic simulator 3A in the simulator linkage information 23 to "received" (c113). Additionally, the execution determination unit 12 updates the current position and the movement status ("moving") included in the simulation result to the [traffic] current position and the [traffic] movement status in the object internal information 25 (c114). The object management unit 10 of "person B" performs the same processing as that of the object management unit 10 of "person A".

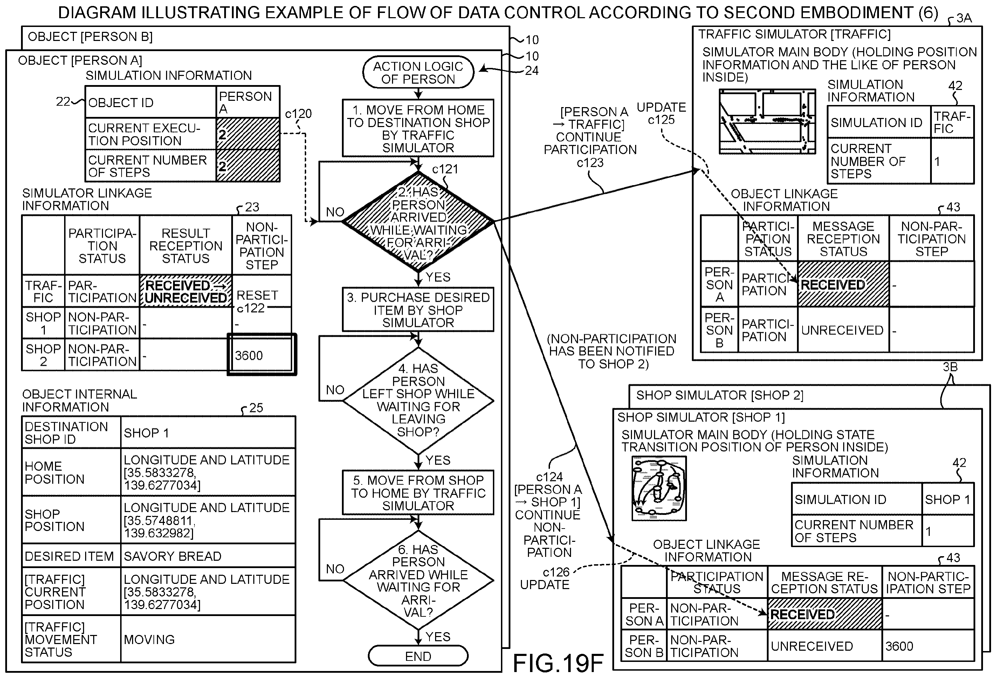

As illustrated in FIG. 19F, in the object management unit 10 of "person A", if result reception statuses corresponding to all of the participating simulators 3 are "received", the execution determination unit 12 determines to execute the next logic processing. Herein, the participating simulator 3 is only the traffic simulator 3A and the result reception status corresponding to the traffic simulator 3A is "received", so that the execution determination unit 12 determines to execute the next logic processing.

The logic execution unit 13 then updates, for the simulation information 22, the current execution position of the action logic to "2", and updates the current number of steps to "2" (c120). The logic execution unit 13 then executes the second logic processing of the action logic (c121). Herein, the second logic processing of "has person arrived while waiting for arrival?" is executed. The logic execution unit 13 then determines participation in the traffic simulator 3A based on an execution result of the logic processing, and sets the participation status corresponding to the traffic simulator 3A in the simulator linkage information 23 to "participation". Additionally, the transmission destination determination unit 14 determines the traffic simulator 3A the participation status of which is "participation" to be a transmission destination of a participation message with reference to the simulator linkage information 23, and updates the reception status to "unreceived" (c122).

The transmission destination determination unit 14A also determines the shop simulator 3B of "shop 1" the participation status of which is "non-participation" to be the transmission destination of the non-participation message with reference to the simulator linkage information 23. The transmission destination determination unit 14A then determines, to be the simulator 3 to which the message is not transmitted, the shop simulator 3B of "shop 2" the participation status of which is "non-participation" and the current number of steps of which ("2") is equal to or smaller than the non-participation step ("3600") with reference to the simulator linkage information 23 and the simulation information 22. Thus, the message is not transmitted to the shop simulator 3B of "shop 2".

The transmission unit 17 then transmits a participation continuation message to the traffic simulator 3A as the transmission destination determined by the transmission destination determination unit 14A (c123). The transmission unit 17 transmits a non-participation continuation message to the shop simulator 3B of "shop 1" as the transmission destination determined by the transmission destination determination unit 14 (c124).

In the traffic simulator 3A that has received the participation continuation message from the object management unit 10 of "person A", the participation status setting unit 32 updates the message reception status corresponding to "person A" in the object linkage information 43 to "received" (c125).

In the shop simulator 3B of "shop 1" that has received the non-participation continuation message from the object management unit 10 of "person A", the participation status setting unit 32 updates the message reception status corresponding to "person A" in the object linkage information 43 to "received" (c126).

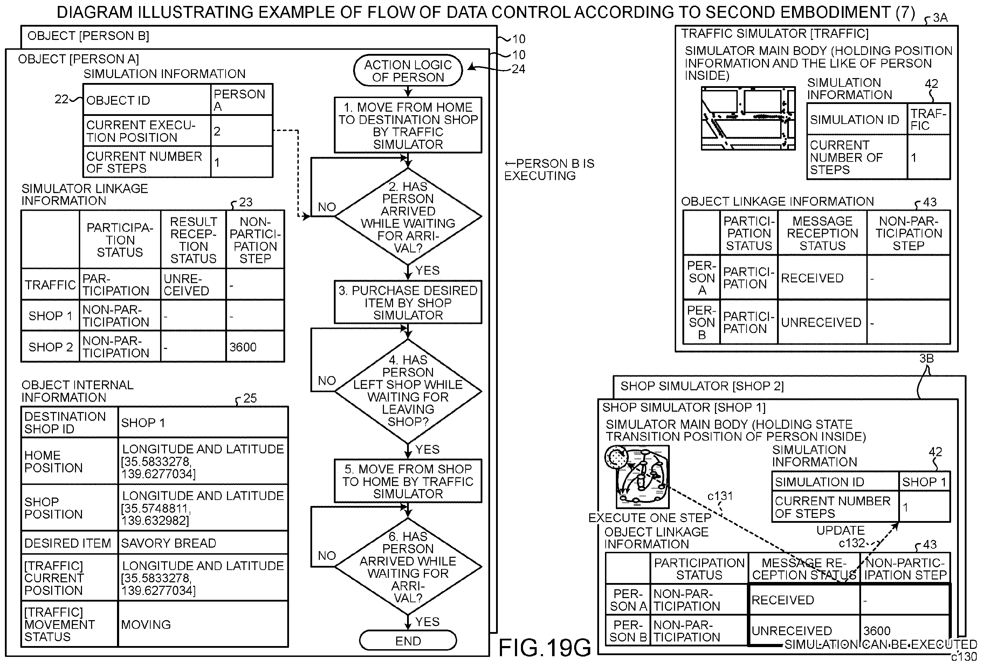

As illustrated in FIG. 19G, in the shop simulator 3B of "shop 1", if the reception statuses corresponding to all of the objects are not "received" but the non-participation step corresponding to the object the reception status of which is not "received" is equal to or larger than the current number of steps, the execution determination unit 33A determines that the simulation can be executed. Herein, in the object linkage information 43, the message reception status corresponding to "person A" is "received" but the message reception status corresponding to "person B" is "unreceived". However, the non-participation step ("3600") corresponding to "person B" is equal to or larger than the current number of steps ("1"), so that the execution determination unit 33A determines that the next simulation can be executed (c130). Due to this, even if the reception statuses corresponding to some of the objects are not "received", the execution determination unit 33A can execute the next simulation step without waiting for reception for the non-participation step, so that a waiting time can be shortened.

In the shop simulator 3B of "shop 1", the execution determination unit 33A has determined that the simulation can be executed, so that the simulator execution unit 34 executes one step of simulation (c131). The simulator execution unit 34 then updates the current number of steps in the simulation information 42 to 1 (c132).

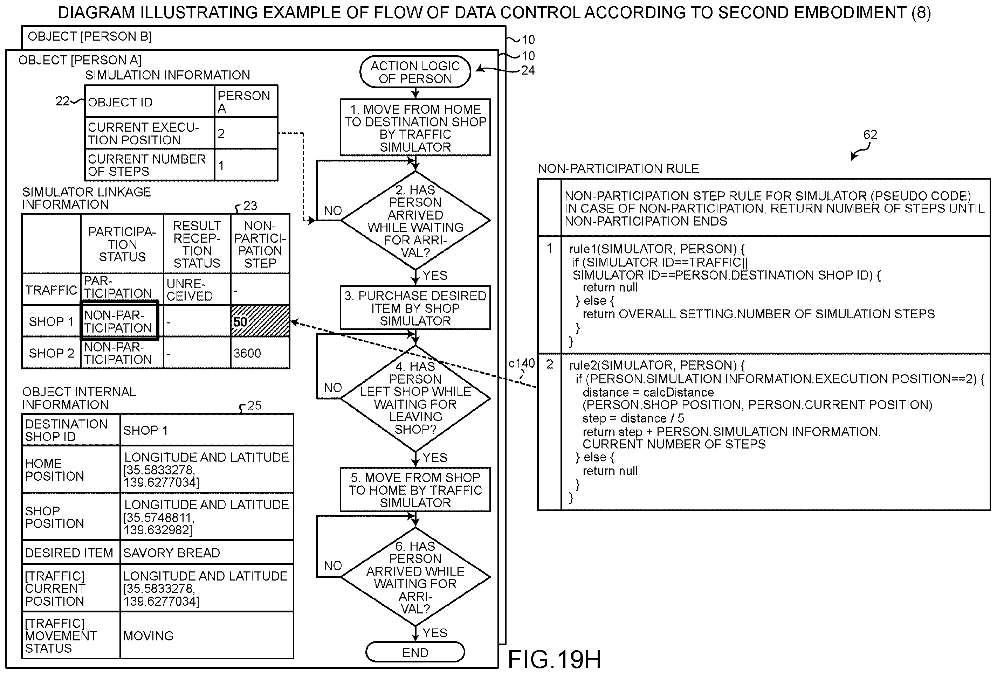

As illustrated in FIG. 19H, for the object management unit 10 of "person A", the non-participation step number determination unit 61 applies the non-participation rule 62 to each simulator 3 of "non-participation" again while waiting for a simulation result. Herein, the target is "shop 1" to which the non-participation step is not set in the simulator linkage information 23.

For example, "shop 1" is the destination shop, so that the non-participation step number determination unit 61 determines that it does not match the rule 1 of the non-participation rule 62. Next, the non-participation step number determination unit 61 determines that it matches the rule 2 of the non-participation rule 62 when waiting for arrival at the destination shop. Herein, the destination shop ID in the object internal information 25 is "shop 1" and the movement status is "moving", so that the non-participation step number determination unit 61 determines that it matches the rule 2 of the non-participation rule 62. Thus, the non-participation step number determination unit 61 calculates the minimum number of steps from the current position to the shop position as the number of non-participation steps based on the rule 2 of the non-participation rule 62, and determines non-participation in the shop simulator 3B of "shop 1" as the destination shop for the calculated number of steps. Herein, the calculated number of non-participation steps (minimum number of steps) is assumed to be "50". The non-participation step number determination unit 61 then updates the non-participation step corresponding to "shop 1" in the simulator linkage information 23 to the determined number of non-participation steps "50" (c140).

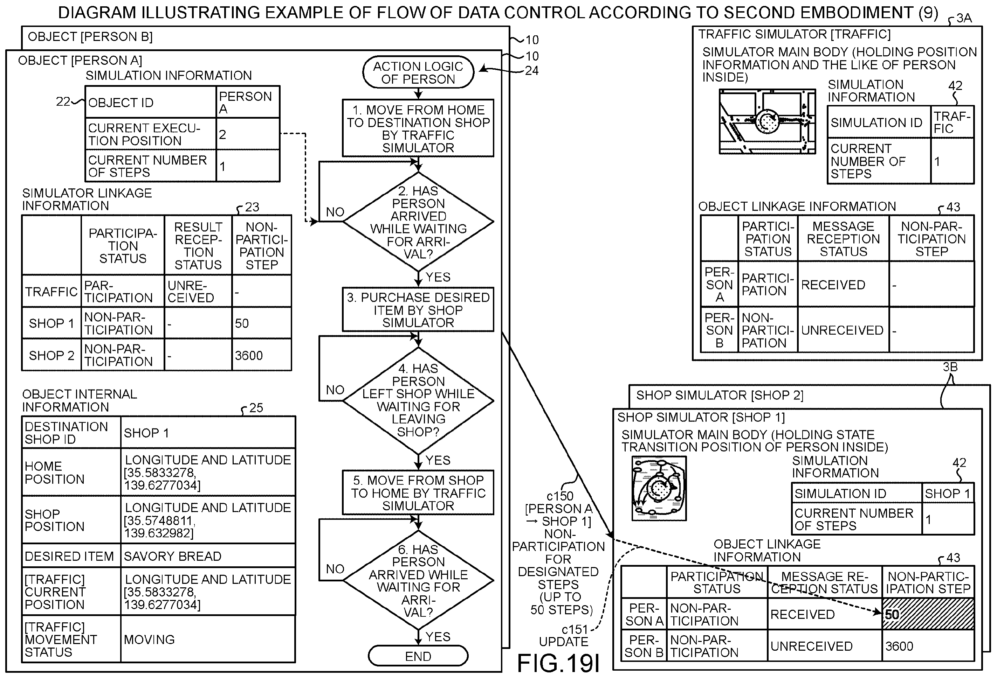

As illustrated in FIG. 19I, for the object management unit 10 of "person A", the non-participation step number determination unit 61 notifies, via the transmission unit 17, the shop simulator 3B of "shop 1" of a non-participation message indicating non-participation for the number of non-participation steps "50" (c150).

In the shop simulator 3B of "shop 1", the participation status setting unit 32A updates the non-participation step corresponding to "person A" in the object linkage information 43 to "50" (c151).

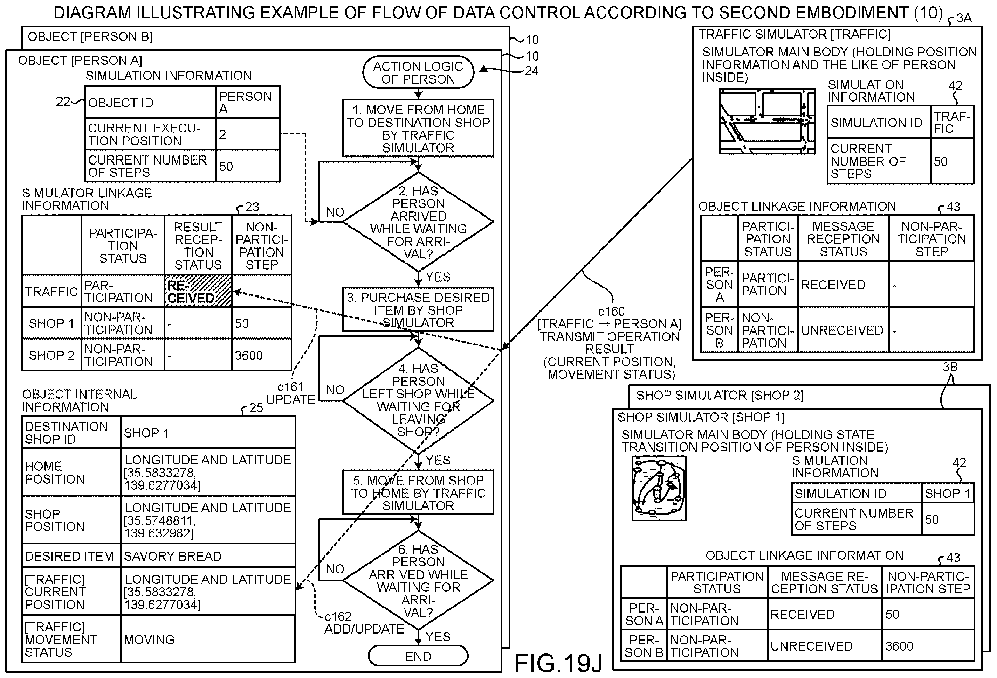

In FIG. 19J, it is assumed that the current number of steps reaches 50 steps after a certain period of operation. In the simulation information 22 and 42, the current number of steps indicates "50".

As illustrated in FIG. 19J, in the traffic simulator 3A, the transmission unit 38 transmits the simulation result including the current position and the movement status to the object management unit 10 of "person A" as the transmission destination determined by the transmission destination determination unit 35 (c160). In the object management unit 10 of "person A", when receiving the simulation result from the participating traffic simulator 3A, the execution determination unit 12 updates the result reception status corresponding to the traffic simulator 3A in the simulator linkage information 23 to "received" (c161). Additionally, the execution determination unit 12 sets the current position and the movement status included in the simulation result to the [traffic] current position and the [traffic] movement status in the object internal information 25 (c162). Herein, it is assumed that "moving" is set to the [traffic] movement status.

At a stage where 50 steps have elapsed, it is expected that "person A" has not arrived at "shop 1" as the destination shop. This is because 50 steps are the minimum number of steps calculated by using the non-participation rule 62. If a simulation result including "arrived" as the movement status is received from the traffic simulator 3A, the non-participation rule 62 is incorrect. In such a case, the object management unit 10 ends with an error.

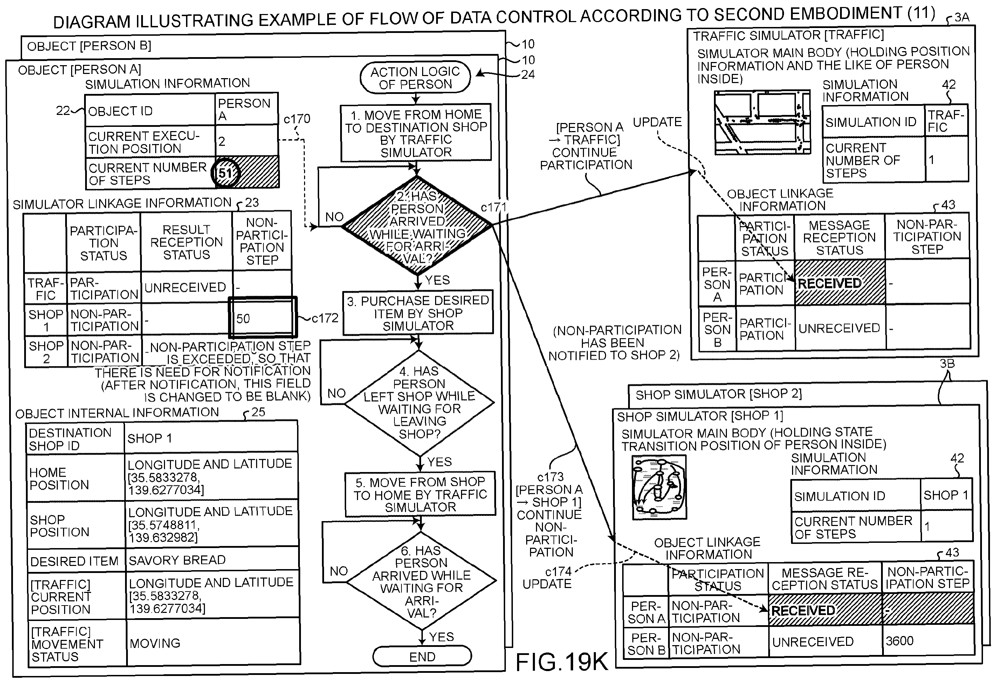

As illustrated in FIG. 19K, in the object management unit 10 of "person A", if result reception statuses corresponding to all of the participating simulators 3 are "received", the execution determination unit 12 determines to execute the next logic processing. Herein, the participating simulator 3 is only the traffic simulator 3A and the result reception status corresponding to the traffic simulator 3A is "received", so that the execution determination unit 12 determines to execute the next logic processing.

The logic execution unit 13 then updates, for the simulation information 22, the current execution position of the action logic to "2", and updates the current number of steps to "51" (c170). The logic execution unit 13 then executes the second logic processing of the action logic (c171). Herein, the second logic processing of "has person arrived while waiting for arrival?" is executed. The logic execution unit 13 then determines participation in the traffic simulator 3A based on an execution result of the logic processing, and sets the participation status corresponding to the traffic simulator 3A in the simulator linkage information 23 to "participation". Additionally, the transmission destination determination unit 14A determines the traffic simulator 3A the participation status of which is "participation" to be a transmission destination of a participation message with reference to the simulator linkage information 23, and updates the reception status to "unreceived".

The transmission destination determination unit 14A also determines, to be the transmission destination of the non-participation message, the simulator 3 the participation status of which is "non-participation" and the current number of steps of which exceeds the non-participation step with reference to the simulation information 42 and the simulator linkage information 23. Herein, the current number of steps is "51" and the non-participation step corresponding to "shop 1" is "50", so that the transmission destination determination unit 14A determines the shop simulator 3B of "shop 1" to be the transmission destination of the non-participation message (c172). That is, the current number of steps exceeds the non-participation step for "shop 1", so that the participation status needs to be notified to "shop 1" again. Thereafter, for the simulator linkage information 23, the transmission destination determination unit 14A sets the reception status and the non-participation step corresponding to "shop 1" to "-" to be cleared.

The transmission unit 17 then transmits a participation continuation message to the traffic simulator 3A as the transmission destination determined by the transmission destination determination unit 14A. The transmission unit 17 transmits a non-participation continuation message to the shop simulator 3B of "shop 1" as the transmission destination determined by the transmission destination determination unit 14A (c173).

In the traffic simulator 3A that has received the participation continuation message from the object management unit 10 of "person A", the participation status setting unit 32 updates the message reception status corresponding to "person A" in the object linkage information 43 to "received".

In the shop simulator 3B of "shop 1" that has received the non-participation continuation message from the object management unit 10 of "person A", the participation status setting unit 32 updates the message reception status corresponding to "person A" in the object linkage information 43 to "received". Additionally, the participation status setting unit 32 updates the non-participation step corresponding to "person A" in the object linkage information 43 to "-" (c174).

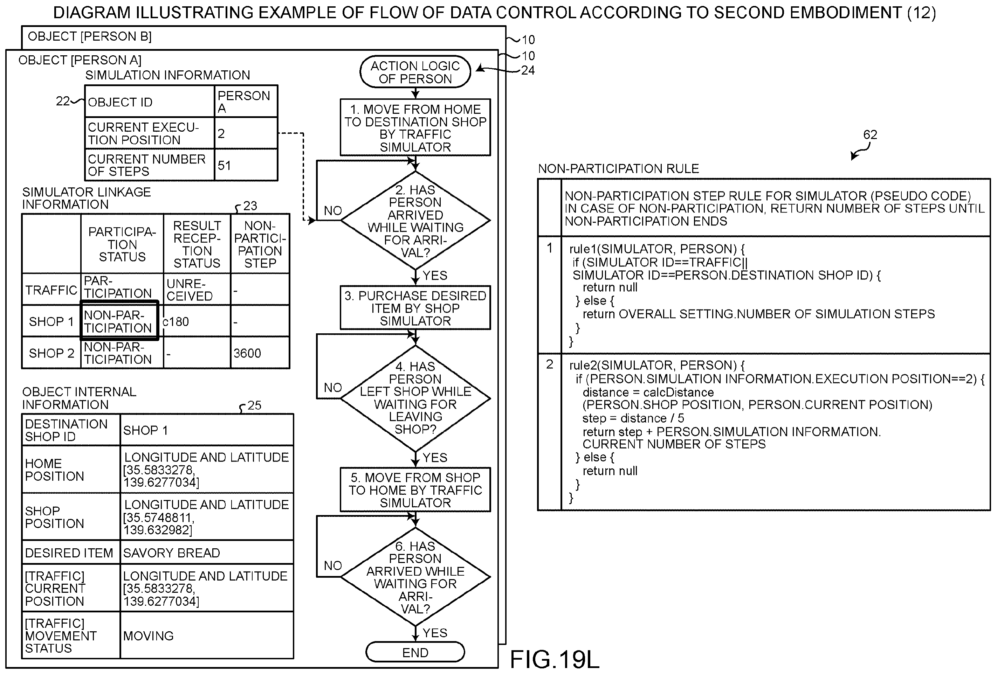

As illustrated in FIG. 19L, thereafter, for the object management units 10 of "person A" and "person B", the non-participation step number determination unit 61 applies the non-participation rule 62 to each simulator 3 of "non-participation" again while waiting for a simulation result (c180). If the non-participation rule 62 is matched, the non-participation step number determination unit 61 then determines non-participation in the relevant shop simulator 3B for the number of steps determined based on the non-participation rule 62, and notifies the non-participation via the transmission unit 17.

### <Flowchart of object management processing>

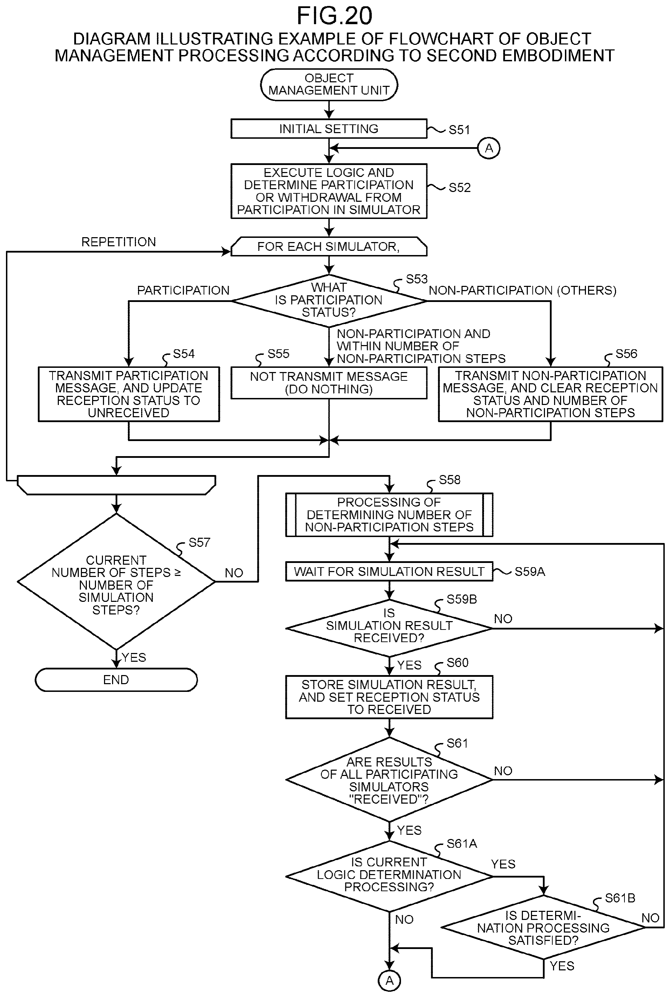

The following describes a flowchart of object management processing performed by the object management unit 10 with reference to FIG. 20. FIG. 20 is a diagram illustrating an example of the flowchart of the object management processing according to the second embodiment. It is assumed that the object management unit 10 has received an instruction to start simulation execution from the simulation execution management unit 5.

As illustrated in FIG. 20, the object management unit 10 that has received the instruction to start simulation execution performs initial setting (Step S51).

The object management unit 10 then executes the logic, and determines participation, non-participation, or withdrawal from participation in the simulator 3 based on an execution result (Step S52).

Subsequently, the object management unit 10 performs Step S53 to Step S56 for each simulator 3. That is, the object management unit 10 determines the participation status with reference to the simulator linkage information 23 (Step S53). If the participation status is "participation" (participation at Step S53), the object management unit 10 transmits the participation message to the relevant simulator 3, and updates the reception status of the simulator linkage information 23 to "unreceived" (Step S54).

If the participation status is "non-participation" and the current number of steps is equal to or smaller than the number of non-participation steps (non-participation and within the number of non-participation steps at Step S53), the object management unit 10 does not transmit anything (Step S55). The current number of steps may be acquired from the simulation information 22. The number of non-participation steps may be acquired from the non-participation step corresponding to the relevant simulator 3 in the simulator linkage information 23.

If the participation status is "non-participation" (others) (non-participation (others) at Step S53), the object management unit 10 transmits the non-participation message, and clears the reception status and the number of non-participation steps (Step S56). For example, the object management unit 10 transmits the non-participation message to the relevant simulator 3 in a case in which the participation status is "non-participation" and the non-participation step is not set, or in a case in which the participation status is "non-participation" and the current number of steps exceeds the number of non-participation steps. The object management unit 10 then sets the reception status and the non-participation step corresponding to the relevant simulator 3 in the simulator linkage information 23 to "-".

After completing determination of the participation status for each simulator 3, the object management unit 10 determines whether the current number of steps is equal to or larger than the number of simulation steps to determine the end (Step S57). For example, the object management unit 10 acquires the current number of steps from the simulation information 22. The object management unit 10 also acquires the number of simulation steps from the overall information 21. The object management unit 10 then determines whether the current number of steps is equal to or larger than the number of simulation steps.

If it is determined that the current number of steps is equal to or larger than the number of simulation steps (Yes at Step S57), the object management unit 10 ends the object management processing.

On the other hand, if it is determined that the current number of steps is smaller than the number of simulation steps (No at Step S57), the object management unit 10 performs processing of determining the number of non-participation steps (Step S58). A flowchart of the processing of determining the number of non-participation steps will be described later.

Subsequently, the object management unit 10 waits for a simulation result from the simulator 3 (Step S59A). The object management unit 10 determines whether the simulation result has been received from the simulator 3 (Step S59B). If it is determined that the simulation result has not been received from the simulator 3 (No at Step S59B), the object management unit 10 repeats the determination processing until the simulation result is received.

On the other hand, if it is determined that the simulation result has been received from the simulator 3 (Yes at Step S59B), the object management unit 10 stores the simulation result in the object internal information 25. Additionally, the object management unit 10 sets the reception status of the simulator linkage information 23 to "received" (Step S60).

The object management unit 10 then determines whether results of all of the participating simulators 3 are received (Step S61). If it is determined that the results of all of the participating simulators 3 are not received (No at Step S61), the object management unit 10 advances the process to Step S59A to receive the next simulation result.

On the other hand, if it is determined that the results of all of the participating simulators 3 are received (Yes at Step S61), the object management unit 10 determines whether current logic is determination processing (Step S61A). If it is determined that the current logic is not the determination processing (No at Step S61A), the object management unit 10 advances the process to Step S52 to execute the next logic.

On the other hand, if it is determined that the current logic is the determination processing (Yes at Step S61A), the object management unit 10 determines whether the determination processing is satisfied with reference to the object internal information 25 (Step S61B). If it is determined that the determination processing is not satisfied (No at Step S61B), the object management unit 10 advances the process to Step S59A to receive the next simulation result.

On the other hand, if it is determined that the determination processing is satisfied (Yes at Step S61B), the object management unit 10 advances the process to Step S52 to execute the next logic.

### <Flowchart of processing of determining number of non-participation steps (when non-participation rule is used)>

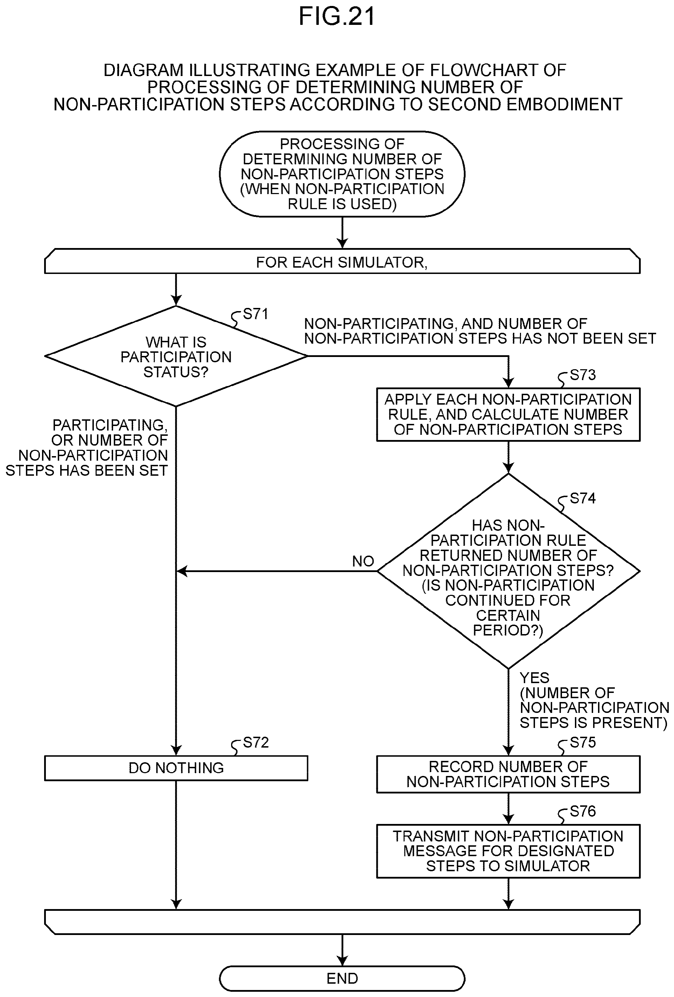

FIG. 21 is a diagram illustrating an example of a flowchart of the processing of determining the number of non-participation steps according to the second embodiment. With reference to FIG. 21, the following describes the flowchart of the processing of determining the number of non-participation steps when the non-participation rule 62 is used.

The object management unit 10 performs Step S71 to Step S76 for each simulator 3. That is, the object management unit 10 determines the participation status with reference to the simulator linkage information 23 (Step S71). If the participation status is "participation" or the non-participation step has been set (during participation, or when the number of non-participation steps has been set at Step S71), the object management unit 10 does nothing (Step S72).

On the other hand, if the participation status is "non-participation" and the non-participation step has not been set (non-participation, and the number of non-participation steps has not been set at Step S71), the object management unit 10 calculates the number of non-participation steps while applying each non-participation rule (Step S73). The object management unit 10 then determines whether the non-participation rule 62 has returned the number of non-participation steps (Step S74). If it is determined that the non-participation rule 62 has not returned the number of non-participation steps (No at Step S74), the object management unit 10 does nothing (Step S72).

On the other hand, it is determined that the non-participation rule 62 has returned the number of non-participation steps (Yes at Step S74), the object management unit 10 records the number of non-participation steps in the simulator linkage information 23 (Step S75). The object management unit 10 then transmits the non-participation message indicating non-participation for the number of non-participation steps to the relevant simulator 3 (Step S76).

When the processing from Step S71 to Step S76 is completely performed for each simulator 3, the object management unit 10 ends the processing of determining the number of non-participation steps.

### <Flowchart of processing of determining number of non-participation steps (logic pre-reading)>

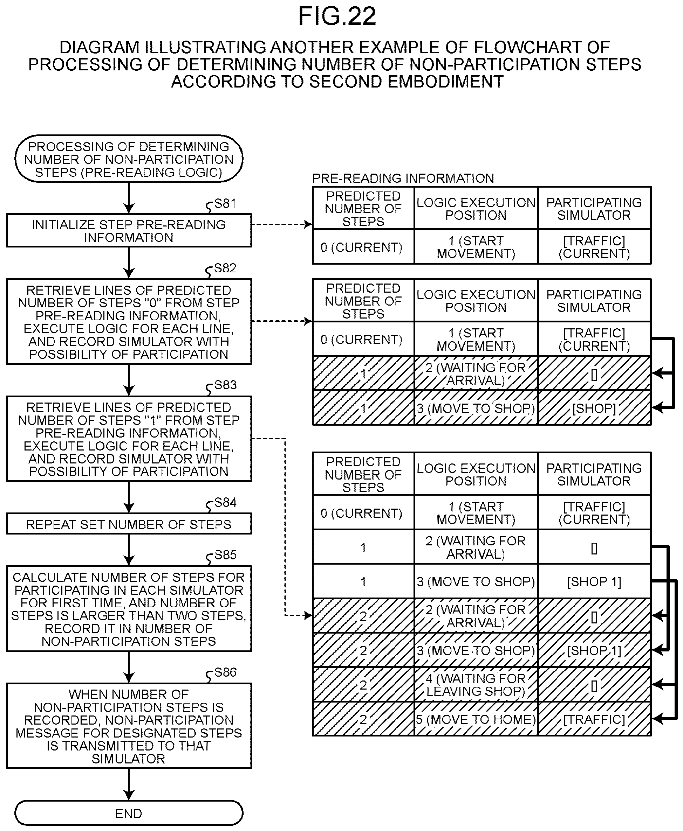

FIG. 22 is a diagram illustrating another example of the flowchart of the processing of determining the number of non-participation steps according to the second embodiment. With reference to FIG. 22, the following describes the flowchart of the processing of determining the number of non-participation steps in a case of using logic pre-reading for the logic in the object logic information 24 illustrated in FIG. 17.

The object management unit 10 initializes the pre-reading information 63 (Step S81). For example, in a case in which a predicted number of steps is "0" (current), "1" (start movement) is set as a logic execution position and "traffic" (current) indicating the traffic simulator 3A as a participating simulator is set to the pre-reading information 63. The logic execution position "1" indicates "move from home to destination shop by traffic simulator" in the logic.

The object management unit 10 then retrieves lines of the predicted number of steps "0" from the pre-reading information 63. The object management unit 10 executes the logic for each of the lines, and records the simulator 3 with a possibility of participation (Step S82). At this point, if the logic includes conditional branches, the object management unit 10 records all of the conditional branches. For example, it is assumed that the object management unit 10 has executed logic processing indicated by the logic execution position "1" in the line of the predicted number of steps "0". Accordingly, when a predicted step "1" has elapsed, the logic execution position remains at "2" if the simulation result is "waiting for arrival". The logic execution position "2" indicates "has object arrived while waiting for arrival?" in the logic. Thus, in such a case, the simulator 3 in which the object is to participate is not yet determined. When the simulation result arrives immediately, there is a possibility of moving to the shop, so that the logic execution position is shifted to "3". The logic execution position "3" indicates "purchase desired item by shop simulator" in the logic. Thus, in such a case, the simulator 3 in which the object is to participate is "shop".

The object management unit 10 then retrieves lines of the predicted number of steps "1" from the pre-reading information 63. The object management unit 10 executes the logic for each of the lines, and records the simulator 3 with a possibility of participation (Step S83). At this point, if the logic includes conditional branches, the object management unit 10 records all of the conditional branches.

The object management unit 10 then repeats the processing for the number of steps set in advance (Step S84). For example, the object management unit 10 adds 1 to the predicted number of steps. The object management unit 10 then retrieves lines of the predicted number of steps from the pre-reading information 63. The object management unit 10 executes the logic for each of the lines, and records the simulator 3 with a possibility of participation. The object management unit 10 repeats the processing until the predicted number of steps reaches the number of steps set in advance.

The object management unit 10 then calculates the number of steps for participating in each simulator 3 for the first time with reference to the pre-reading information 63. If the calculated number of steps is larger than two steps, the object management unit 10 records the number of steps in the non-participation step corresponding to the relevant simulator 3 in the simulator linkage information 23 (Step S85). Herein, there is a possibility of participation in "shop 1" after one step. As a result, "shop 1" is not recorded in the number of non-participation steps. There is no possibility of participation in "shop 2" for at least two steps ahead. As a result, "shop 2" is recorded in the number of non-participation steps up to the current number of steps + 2.

In a case of recording the number of non-participation steps, the object management unit 10 transmits the non-participation message indicating non-participation for the number of non-participation steps to the relevant simulator 3 (Step S86). The object management unit 10 then ends the processing of determining the number of non-participation steps.

### <Flowchart of simulator management processing>

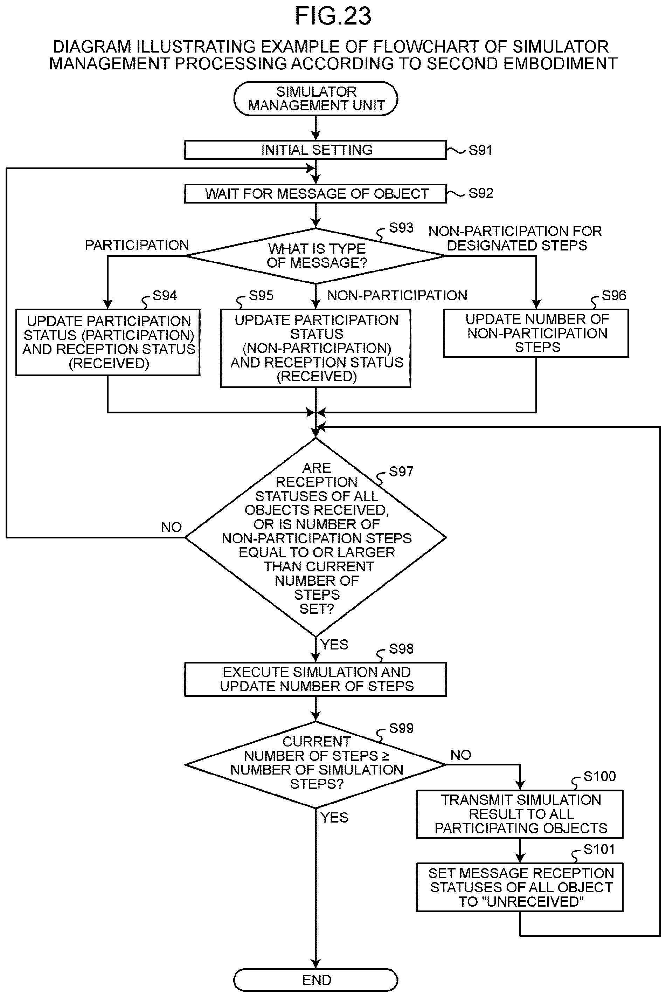

The following describes a flowchart of simulator management processing performed by the simulator management unit 30 with reference to FIG. 23. FIG. 23 is a diagram illustrating an example of the flowchart of the simulator management processing according to the second embodiment. It is assumed that the simulator management unit 30 has received an instruction to start simulation execution from the simulation execution management unit 5.

As illustrated in FIG. 23, the simulator management unit 30 that has received the instruction to start simulation execution performs initial setting (Step S91).

The simulator management unit 30 waits for a message of the object transmitted from the object management unit 10 (Step S92). When receiving the message, the simulator management unit 30 determines a type of the message (Step S93). If the type of the message is determined to be participation (participation at Step S93), the simulator management unit 30 updates the participation status of the object linkage information 43 to "participation", and updates the reception status to "received" (Step S94). The simulator management unit 30 then advances the process to Step S97.

If the type of the message is determined to be non-participation (or withdrawal from participation) (non-participation at Step S93), the simulator management unit 30 updates the participation status of the object linkage information 43 to "non-participation", and updates the reception status to "received" (Step S95). The simulator management unit 30 then advances the process to Step S97.

If it is determined that the type of the message is non-participation for designated steps (non-participation for designated steps at Step S93), the simulator management unit 30 updates the non-participation step in the object linkage information 43 to the designated number of steps (Step S96). The simulator management unit 30 then advances the process to Step S97.

At Step S97, with reference to the object linkage information 43, the simulator management unit 30 determines whether the reception statuses of all of the objects are "received", or even if they are not "received", determines whether the number of non-participation steps is equal to or larger than the current number of steps is set (Step S97). If it is determined that the reception status of any of the objects is not "received" and the number of non-participation steps is not set for the object the reception status of which is not "received" (No at Step S97), the simulator management unit 30 advances the process to Step S92 to wait for the next message.

On the other hand, if it is determined that the reception statuses of all of the objects are "received", or even if they are not "received", when it is determined that the number of non-participation steps is equal to or larger than the current number of steps is set (Yes at Step S97), the simulator management unit 30 performs the following processing. The simulator management unit 30 executes the simulation, and updates the current number of steps in the simulation information 42 (Step S98). That is, if the reception statuses corresponding to all of the objects are not "received", the simulator management unit 30 executes the simulation when the non-participation step corresponding to the object the reception status of which is not "received" is equal to or larger than the current number of steps. Accordingly, even if the reception statuses corresponding to some of the objects are not "received", the simulator management unit 30 can execute the next simulation step without waiting for reception for the non-participation step, so that a waiting time can be shortened.

The simulator management unit 30 then determines whether the current number of steps is equal to or larger than the number of simulation steps to determine the end (Step S99). For example, the simulator management unit 30 acquires the current number of steps from the simulation information 22. The simulator management unit 30 acquires the number of simulation steps from the overall information 21. The simulator management unit 30 then determines whether the current number of steps is equal to or larger than the number of simulation steps.

If it is determined that the current number of steps is equal to or larger than the number of simulation steps (Yes at Step S99), the simulator management unit 30 ends the simulator management processing.

On the other hand, if it is determined that the current number of steps is smaller than the number of simulation steps (No at Step S99), the simulator management unit 30 transmits simulation results to all participating objects (Step S100). The simulator management unit 30 then sets message reception statuses of all objects in the object linkage information 43 to "unreceived" (Step S101). The simulator management unit 30 then advances the process to Step S97.

### <Effect of second embodiment>

According to the second embodiment described above, the object management unit 10 determines non-participation in some of the simulators 3 and the non-participation period based on a predetermined method. The object management unit 10 transmits the non-participation for the non-participation period to the determined simulator 3, and holds the non-participation for the non-participation period in the participation status for the simulator 3 in the participation status storage unit. The object management unit 10 does not transmit data of the target to the determined simulator 3 only in the non-participation period. With such a configuration, the object management unit 10 does not transmit data to the simulator 3 only in the non-participation period, so that communication cost can be suppressed.

According to the second embodiment described above, the simulator 3 that has received the non-participation only in the non-participation period executes the simulation without waiting for reception of the data of the target until the non-participation period. With such a configuration, the simulator 3 can execute the next step simulation without waiting for data from the target only in the non-participation period, and a waiting time can be shortened.

According to the second embodiment described above, the predetermined method uses the non-participation rule for acquiring the specific non-participating simulator 3 and the non-participation period using an attribute of the target. With such a configuration, the object management unit 10 can acquire the non-participating simulator 3 and the non-participation period using the non-participation rule. As a result, the object management unit 10 can execute the next logic without waiting for a simulation result of the non-participating simulator 3, and the waiting time can be shortened. The simulator 3 can execute the next step simulation without waiting for data from the target only in the non-participation period, and the waiting time can be shortened.

According to the second embodiment described above, the non-participation rule is used for acquiring the specific non-participating simulator 3 and the non-participation period using the position information of the target obtained from the first simulator 3. With such a configuration, the object management unit 10 can acquire the non-participating simulator 3 and the non-participation period using the non-participation rule. As a result, the object management unit 10 can execute the next logic without waiting for a simulation result of the non-participating simulator 3, and the waiting time can be shortened. The simulator 3 can execute the next step simulation without waiting for data from the target only in the non-participation period, and the waiting time can be shortened.

According to the second embodiment described above, in the predetermined method, the specific non-participating simulator 3 and the non-participation period are acquired using a result of pre-reading the logic. With such a configuration, the object management unit 10 can acquire the non-participating simulator 3 and the non-participation period without using the non-participation rule. As a result, the object management unit 10 can execute the next logic without waiting for a simulation result of the non-participating simulator 3, and the waiting time can be shortened. The simulator 3 can execute the next step simulation without waiting for data from the target only in the non-participation period, and the waiting time can be shortened.

### <Others>

In the first and the second embodiments described above, the constituent elements of the data control device 1 illustrated in the drawings are not necessarily physically configured as illustrated. That is, specific forms of distribution and integration of the data control device 1 are not limited to those illustrated in the drawings. All or some thereof may be functionally or physically distributed/integrated in arbitrary units depending on various loads or usage states. A storage unit (not illustrated) that stores therein information such as the overall information 21 may be connected via a network as an external device of the data control device 1. Furthermore, the object management unit 10 may be placed on a cloud, and a user can connect to the cloud from a terminal and the like via a network to use processing performed by the object management unit 10. In this manner, the processing of the present invention can be provided as a service.

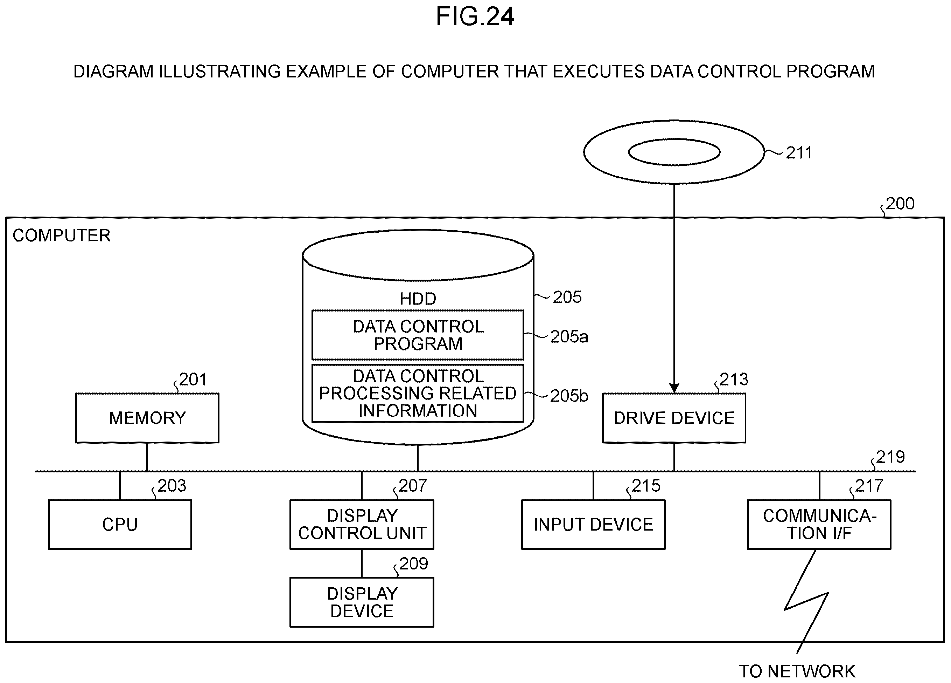

The various kinds of processing described in the above embodiments can be implemented by executing computer programs prepared in advance by a computer such as a personal computer or a workstation. The following describes an example of a computer that executes a data control program that implements the same function as that of the object management unit 10 illustrated in FIG. 1. FIG. 24 is a diagram illustrating an example of the computer that executes the data control program.

As illustrated in FIG. 24, a computer 200 includes a central processing unit (CPU) 203 that executes various kinds of arithmetic processing, an input device 215 that receives data input from the user, and a display device 209. The computer 200 also includes a drive device 213 that reads a computer program and the like from a storage medium, and a communication interface (I/F) 217 that exchanges data with other computers via a network. The computer 200 further includes a memory 201 that temporarily stores therein various kinds of information, and a hard disk drive (HDD) 205. The memory 201, the CPU 203, the HDD 205, the display device 209, the drive device 213, the input device 215, and the communication I/F 217 are connected via a bus 219.

The drive device 213 is, for example, a device for a removable disk 211. The HDD 205 stores therein a data control program 205a and data control processing related information 205b. The communication I/F 217 serves as an interface between the network and an inner part of the device, and controls input/output of data to/from other computers. For the communication I/F 217, for example, a modem, a LAN adapter, and the like can be employed.

The display device 209 is a display device that displays data such as a cursor, an icon, or a toolbox as well as a document, an image, functional information, and the like. For the display device 209, for example, a liquid crystal display, an organic electroluminescence (EL) display, and the like can be employed.

The CPU 203 reads out the data control program 205a to be loaded into the memory 201, and executes it as a process. Such a process corresponds to each functional unit of the object management unit 10. The data control processing related information 205b includes, for example, the overall information 21, the simulation information 22, the simulator linkage information 23, the object logic information 24, and the object internal information 25. For example, the removable disk 211 stores therein pieces of information of the data control program 205a and the like.

The data control program 205a is not necessarily stored in the HDD 205 from the beginning. For example, this program may be stored in a "portable physical medium" such as a flexible disk (FD), a CD-ROM, a DVD disc, a magneto-optical disk, or an IC card to be inserted into the computer 200. The computer 200 may then read out, from these media, and execute the data control program 205a.

The data control method performed by the data control device 1 described in the first and the second embodiments can be applied to social simulations used in a local government or a transportation infrastructure, for example.

### Explanation of Reference

1 DATA CONTROL DEVICE
3 SIMULATOR
5 SIMULATION EXECUTION CONTROL UNIT
9 DATA CONTROL SYSTEM
10 OBJECT MANAGEMENT UNIT
11, 31 INITIAL SETTING UNIT
12, 33, 33A EXECUTION DETERMINATION UNIT
13 LOGIC EXECUTION UNIT
14, 14A, 35 TRANSMISSION DESTINATION DETERMINATION UNIT
15, 36 END DETERMINATION UNIT
16, 37 RECEPTION UNIT
17, 38 TRANSMISSION UNIT
21, 41 OVERALL INFORMATION
22, 42 SIMULATION INFORMATION
23 SIMULATOR LINKAGE INFORMATION
24 OBJECT LOGIC INFORMATION
25 OBJECT INTERNAL INFORMATION
30 SIMULATOR MANAGEMENT UNIT
32, 32A PARTICIPATION STATUS SETTING UNIT
34 SIMULATOR EXECUTION UNIT
43 OBJECT LINKAGE INFORMATION
61 NON-PARTICIPATION STEP NUMBER DETERMINATION UNIT
62 NON-PARTICIPATION RULE
63 PRE-READING INFORMATION

## Claims

1. A data control method for linking pieces of data among a plurality of simulators, the data control method comprising processing of:
by a control unit that controls linkage among the pieces of data,
successively executing logic based on action logic that describes action of a target,
determining, when a fact that the target has moved to a predetermined position is notified from a first simulator in accordance with execution of specific logic, to which of a second simulator and a third simulator data of the target is to be transmitted using an attribute of the target stored in advance, and
transmitting the data of the target to a simulator to which the data of the target is determined to be transmitted.

2. The data control method according to claim 1, wherein
the processing of executing the logic includes:
transmitting, to the first simulator, participation in the first simulator in accordance with content of the logic, and holding the participation in a participation status for the first simulator of a participation status storage unit that stores therein a participation status of the target for each simulator; and
when the fact that the target has moved to the predetermined position is notified from the first simulator, executing the next logic when simulator results are notified from all simulators in which participation is held in the participation status.

3. The data control method according to claim 2, wherein
non-participation in some of the simulators and a non-participation period are determined based on a predetermined method,
non-participation for the non-participation period is transmitted to the determined simulators, and non-participation for the non-participation period is held in the participation status for the simulators in the participation status storage unit, and
the data of the target is not transmitted to the determined simulators for the non-participation period.

4. The data control method according to claim 3, wherein the simulator that has received the non-participation for the non-participation period executes a simulation without waiting for reception of the data of the target until the non-participation period.

5. The data control method according to claim 3, wherein the predetermined method uses a non-participation rule for acquiring a specific non-participating simulator and a non-participation period using an attribute of the target.

6. The data control method according to claim 3, wherein the predetermined method uses a non-participation rule for acquiring a specific non-participating simulator and a non-participation period using position information of the target obtained from the first simulator.

7. The data control method according to claim 3, wherein the predetermined method acquires a specific non-participating simulator and a non-participation period using a result of pre-reading the logic.

8. A data control program for linking pieces of data among a plurality of simulators, the data control program causing a computer to execute processing of:
successively executing logic based on action logic that describes action of a target,
when a fact that the target has moved to a predetermined position is notified from a first simulator in accordance with execution of specific logic, determining to which of a second simulator and a third simulator data of the target is to be transmitted using an attribute of the target stored in advance, and
transmitting the data of the target to a simulator to which the data of the target is determined to be transmitted.

9. The data control program according to claim 8, wherein
the processing of executing the logic includes:
transmitting, to the first simulator, participation in the first simulator in accordance with content of the logic, and holding participation in a participation status for the first simulator of a participation status storage unit that stores therein a participation status of the target for each simulator; and
when a fact that the target has moved to a predetermined position is notified from the first simulator, executing the next logic when simulator results are notified from all simulators in which participation is held in the participation status.

10. The data control program according to claim 9, wherein
the processing includes:
determining non-participation in some of the simulators and a non-participation period based on a predetermined method;
transmitting non-participation for the non-participation period to the determined simulators, and holding non-participation for the non-participation period in the participation status for the simulators in the participation status storage unit, and
not transmitting the data of the target to the determined simulators for the non-participation period.

11. The data control program according to claim 10, wherein the simulator that has received the non-participation for the non-participation period executes a simulation without waiting for reception of the data of the target until the non-participation period.

12. The data control program according to claim 10, wherein the predetermined method uses a non-participation rule for acquiring a specific non-participating simulator and a non-participation period using an attribute of the target.

13. The data control program according to claim 10, wherein the predetermined method uses a non-participation rule for acquiring a specific non-participating simulator and a non-participation period using position information of the target obtained from the first simulator.

14. The data control program according to claim 10, wherein the predetermined method acquires a specific non-participating simulator and a non-participation period using a result of pre-reading the logic.
